# EUROPEAN PATENT APPLICATION

(11) **EP 4 198 382 A1**
(43) Date of publication of application: **21.06.2023**
(21) Application number: 21856101.7
(22) Date of filing: 27.07.2021
(51) Int. Cl.: F21V 13/14, G02B 26/08, F21K 9/00, F21V 23/00, F21S 41/60, F21S 43/40, F21Y 115/10, F21W 107/10, F21W 102/00, F21W 103/00

(54) **LIGHTING DEVICE AND LAMP COMPRISING SAME**

(30) Priority: 11.08.2020 KR 20200100333
(71) Applicant: LG Innotek Co., Ltd., Seoul 07796 (KR)
(72) Inventor: CHOI, Hyun Ho, Seoul 07796 (KR)
(74) Representative: Plasseraud IP
(86) International application number: PCT/KR2021/009747
(87) International publication number: WO 2022/035095

(57) **Abstract**

A lighting device disclosed in an embodiment of the invention includes a substrate, a light emitting device disposed on the substrate, a reflective layer disposed on the substrate, a resin layer disposed on the reflective layer, and a light control member disposed on the resin layer, and the light control member includes a first substrate disposed on the resin layer, a second substrate disposed on the first substrate, and a first adhesive member disposed between the first and second substrates, and comprises a first air gap formed in a region of the region between the first and second substrates in which the first adhesive member is not arranged, and the number of the first air gap may be greater than or equal to a number of the light emitting device.

## Description

### [Technical Field]

The embodiment relates to a lighting device and a lamp including the same.

### [Background Art]

Lighting is a device capable of supplying light or controlling the amount of light and is used in various fields. For example, the lighting device may be applied to various fields such as vehicles and buildings to illuminate the interior or exterior. In particular, in recent years, a light emitting device has been used as a light source for lighting. Such a light emitting device, for example, a light emitting diode (LED), has advantages such as low power consumption, semi-permanent lifespan, fast response speed, safety, environmental friendliness compared to conventional light sources such as fluorescent lamps and incandescent lamps. Such light emitting diodes are being applied to various optical assemblies such as various display devices, indoor lights, or outdoor lights. In general, lamps of various colors and shapes are applied to vehicles, and recently, lamps employing light emitting diodes as light sources for vehicles have been proposed. For example, light emitting diodes are being applied to vehicle headlights, tail lights, turn signals, emblems, and the like. However, such a light emitting diode has a problem in that an exit angle of the emitted light is relatively small. For this reason, when the light emitting diode is used as a vehicle lamp, there is a demand for increasing the light emitting area of the lamp. In addition, when the lamp includes the light emitting diode, there is a problem in that a hot spot is formed by the light emitted from the light emitting diode. When the surface light source is implemented using such a lamp, there is a problem in that the uniformity characteristic of the light emitting surface are deteriorated. Accordingly, there is a need for a new lighting device and lamp capable of solving the above-mentioned problems.

### [Disclosure]

### [Technical Problem]

The embodiment of the invention provides a lighting device and a lamp having improved luminosity. The embodiment of the invention provides a lighting device and a lamp capable of realizing a uniform linear light source or a surface light source.

### [Technical Solution]

The lighting device according to an embodiment of this invention includes a substrate, a light emitting device disposed on the substrate, a reflective layer disposed on the substrate, a resin layer disposed on the reflective layer, and a light control member disposed on the resin layer, wherein the light control member comprises a first substrate disposed on the resin layer, a second substrate disposed on the first substrate, and a first adhesive member disposed between the first and second substrates, wherein a region between the first and second substrates comprises a first air gap formed in a region where the first adhesive member is not disposed, and a number of the first air gap may be greater than or equal to the number of the light emitting device.

According to the embodiment of the invention, the number of the first air gap is provided in plurality, which is greater than the number of light emitting device, and a width of each of the plurality of first air gaps in a horizontal direction may be smaller than a width of the light emitting device in the horizontal direction. A portion of the plurality of first air gaps may be disposed in a region overlapping the light emitting device in a vertical direction. The light control member may further include a third substrate disposed on the second substrate, and a second adhesive member disposed between the second and third substrates, and a region between the second and third substrates comprises a second air gap formed in a region where the second adhesive member is not disposed, and the number of each of the first and second air gaps may be equal to the number of light emitting device. The first and second air gaps may have the same shape and width in the horizontal direction.

According to the embodiment of the invention, a light blocking member disposed between the third substrate and the second air gap include, and a width of the light blocking member in the horizontal direction may be smaller than widths of the first and second air gaps in the horizontal direction. Centers of the first and second air gaps may overlap an optical axis of the light emitting device in a vertical direction. The center of the first air gap may be spaced apart from the optical axis of the light emitting device in the horizontal direction, and the center of the second air gap may overlap an optical axis of the light emitting device in the vertical direction. a light blocking member disposed between the second substrate and the first air gap include, and a width of the light blocking member in the horizontal direction may be greater than a width of the first air gap in the horizontal direction.

The lighting device according to the embodiment of the invention includes a substrate, a light emitting device disposed on the substrate, a reflective layer disposed on the substrate, a resin layer disposed on the reflective layer, and a light control member disposed on the resin layer, and the light control member may include a first substrate disposed on the resin layer, a second substrate disposed between the first and second substrates, wherein a region between the first and second substrates comprises a first air gap formed in where the first adhesive member is not disposed, a light emitting surface of the light emitting device faces a side surface of the resin layer, and the number of the first air gap may be greater than or equal to the number of light emitting device.

According to the embodiment of the invention, the first air gap is provided in plurality, which is greater than the number of light emitting device, and a width of each of the plurality of first air gaps in a horizontal direction may be smaller than a width of the light emitting device in the horizontal direction. A portion of the plurality of first air gaps may be disposed in a region overlapping the light emitting device in the vertical direction. Widths of the plurality of first air gaps in a horizontal direction may decrease as a distance from the light emitting device increases. A width in a horizontal direction of each of the plurality of first air gaps may change from the first substrate toward the second substrate.

### [Advantageous Effects]

The lighting device and lamp according to the embodiment of the invention may have improved light characteristics. In detail, the lighting device and the lamp may include a light control member in which at least one air gap corresponding to a light emitting device is formed in a single layer or multiple layers. Accordingly, the light control member may control a path of light incident on the light control member, and in this process, it is possible to prevent the formation of a hot spot in which light of the light emitting device is concentrated. Therefore, the lighting device and the lamp according to the embodiment may minimize the loss of light during the process of emitting the light emitted from the light emitting device to the outside, and may be implemented as a uniform linear light source or a surface light source.

The Lighting device and the lamp according to the embodiments of the invention have improved luminance and can more effectively prevent hot spots from being formed. In detail, the embodiment includes a light blocking sheet disposed on a region corresponding to the light emitting device to prevent the concentration of emitted light. At this time, the embodiment may minimize the area and size of the light blocking member formed by the light control member including at least one air gap. Accordingly, the lighting device and the lamp according to the embodiment may minimize light loss due to the light blocking member, thereby having improved luminance.

### [Description of Drawings]

FIG. 1 is a side cross-sectional view of a lighting device according to a first embodiment of the invention.
FIG. 2 is a plan view of a reflective layer of the lighting device of FIG. 1.
FIG. 3 is a top view of the lighting device according to FIG. 1.
FIG. 4 is a side cross-sectional view of a lighting device according to the second embodiment of the invention.
FIG. 5 is a top view of the lighting device of FIG. 4.
FIGs. 6, 7, 8 and 9 are side cross-sectional views showing other examples of a lighting device according to the second embodiment of the invention.
FIG. 10 is a side cross-sectional view of a lighting device according to the third embodiment of the invention.
FIG. 11 is a top view of the lighting device of FIG. 10 of the invention.
FIG. 12 is a side cross-sectional view of a lighting device according to the fourth embodiment of the invention.
FIG. 13 is a top view of the lighting device of FIG. 12.
FIGS. 14 and 15 are side cross-sectional views showing another example of a lighting device according to the fourth embodiment of the invention.
FIG. 16 is a top view of a vehicle with a lamp including a lighting device according to the embodiment of the invention.
FIG. 17 is an example of a front lighting device of the vehicle of FIG. 16.
FIG. 18 is an example of a rear lighting device of the vehicle of FIG. 16.

### [Best Mode]

Hereinafter, preferred embodiments of the invention will be described in detail with reference to the accompanying drawings.

The technical idea of the present invention is not limited to some of the described embodiments, but can be implemented in various different forms, and if it is within the scope of the technical idea of the present invention, one or more of its components may be selectively combined and substituted between embodiments. In addition, terms (including technical and scientific terms) used in the embodiments of the present invention, unless explicitly specifically defined and described, may be interpreted as a meaning that may be generally understood by those skilled in the art to which the present invention belongs, and terms generally used, such as terms defined in the dictionary, may be interpreted in consideration of the context of the related technology. Also, terms used in the embodiments of the present invention are for describing the embodiments and are not intended to limit the present invention. In the present specification, the singular form may include a plural form unless specifically described in the phrase, and may include at least one of all combinations that may be combined as A, B, and C when described as "A and/or at least one (or more than one) of B and C". Also, terms such as first, second, A, B, (a), and (b) may be used to describe components of an embodiment of the present invention. These terms are intended only to distinguish the components from other components and are not determined by their nature, sequence, or order. Also, when a component is described as being 'connected', 'coupled' or 'connected' to another component, not only when the component is directly connected, coupled or connected to another component, it may also be 'connected', 'coupled', or 'connected' due to another component between that component and the other component. In addition, when each component is described as being formed or disposed "up (above) or down (bottom)", the up (down) or down (bottom) includes not only when two components are in direct contact with each other, but also when one or more components are formed or disposed between two components. Also, when expressed as "up (above) or down (bottom)", it may include the meaning of not only the upward direction but also the downward direction based on one component.

The lighting device according to the invention may be applied to various lamp devices that require lighting, such as vehicle lamps, household optical assemblies, and industrial optical assemblies. For example, when applied to a vehicle lamp, it may be applied to head lamp, side mirror lights, side maker lights, fog lights, tail lights, brake lights, daytime running lights, vehicle interior lights, door scars, rear combination lamps, backup lamps, etc. In addition, when applied to a vehicle lamp, it is applicable to a rear side assistance system (BSD) disposed in a side mirror or a-pillar, etc. Also, the optical assembly of the present invention can be applied to indoor and outdoor advertising devices, display devices, and various electric vehicle fields, and in addition, it will be said that it can be applied to all lighting-related fields or advertising-related fields that are currently developed and commercialized or can be implemented according to future technological development.

In addition, prior to the description of the embodiment of the invention, the first direction may mean the x-axis direction shown in the drawing, and the second direction may be a direction different from the first direction. For example, the second direction may mean a y-axis direction shown in the drawing as a direction perpendicular to the first direction. Also, the horizontal direction may mean first and second directions, and the vertical direction may mean a direction perpendicular to at least one of the first and second directions. For example, the horizontal direction may mean x-axis and y-axis directions of the drawing, and the vertical direction may be z-axis directions of the drawing and may be directions perpendicular to x-axis and y-axis directions.

### <First Embodiment>

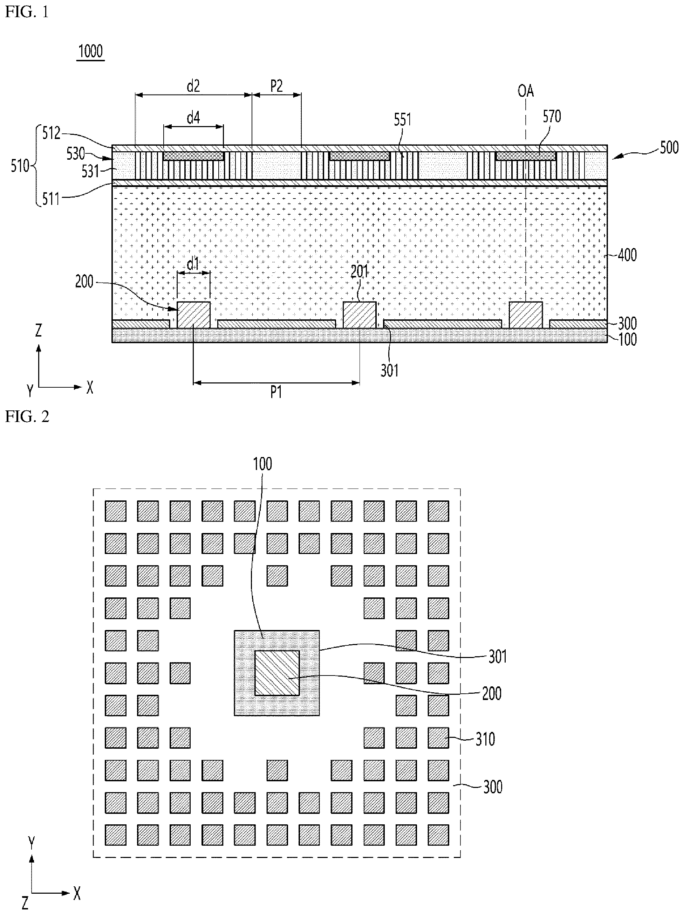

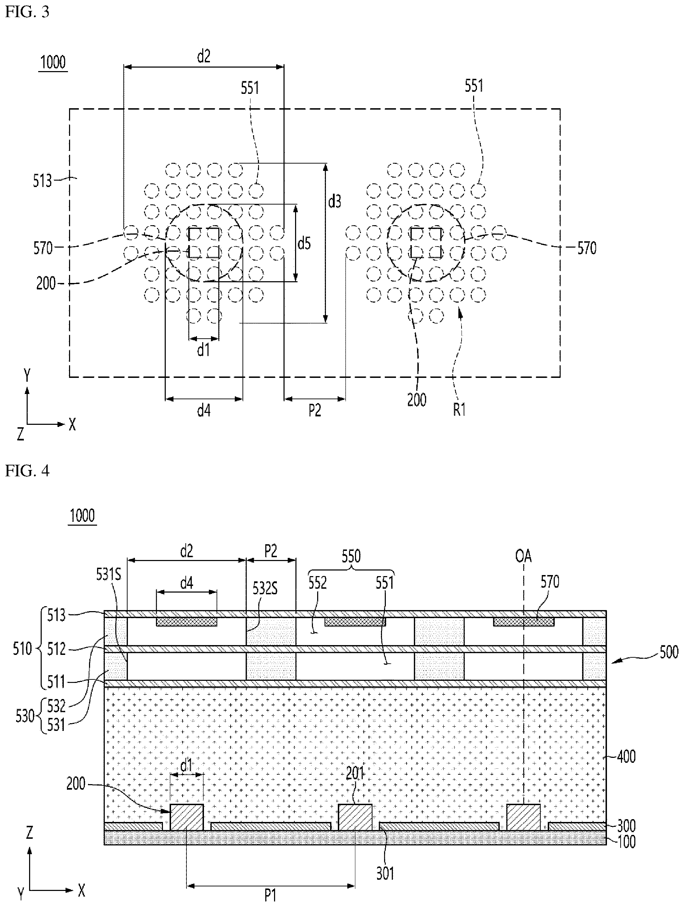

FIG. 1 is a cross-sectional view of a lighting device according to a first embodiment of the invention, FIG. 2 is a plan view of a reflective layer in the lighting device of FIG. 1, and FIG. 3 is a top view of the lighting device of FIG. 1.

Referring to FIGs. 1 to 3, a lighting device 1000 according to the embodiment of the invention may include a substrate 100, a light emitting device 200, a reflective layer 300, a resin layer 400, and a light control member 500. The lighting device 1000 may emit light emitted from the light emitting device 200 as a surface light source. The lighting device 1000 may be defined as a light emitting cell, a lighting module, or a light source module. The lighting device 1000 may include one light emitting cell or a plurality of light emitting cells on the substrate 100.

The substrate 100 may include a Printed Circuit Board (PCB). The substrate 100 may include, for example, at least one of a resin-based Printed Circuit Board (PCB), a metal core PCB, a flexible PCB, a ceramic PCB, or an FR-4 substrate. When the substrate 100 is disposed as a metal core PCB having a metal layer disposed on the bottom, heat dissipation efficiency of the light emitting device 200 may be improved. In addition, the substrate 100 may include a light-transmissive material. In detail, the substrate 100 may include a material through which light is transmitted through upper and lower surfaces. The substrate 100 may include at least one of Polyethylene terephthalate (PET), Polystyrene (PS), Polyimide (PI), Polyethylene naphthalate (PEN), and polycarbonate (PC). The substrate 100 may be electrically connected to the light emitting device 200. The substrate 100 includes a wiring layer (not shown) thereon, and the wiring layer may be electrically connected to the light emitting device 200. When the plurality of light emitting devices 200 are arranged on the substrate 100, the plurality of light emitting devices 200 may be connected in series, parallel, or series-parallel by the wiring layer. The substrate 100 may function as a substrate or a support member disposed below the light emitting device 200 and the resin layer 400.

The light emitting device 200 may be disposed on the substrate 100. The light emitting device 200 is an LED chip emitting light on at least five sides, and may be disposed on the substrate 100 in a flip chip form. The light emitting device 200 may emit at least one of visible light such as blue, red, green, and yellow, ultraviolet (UV) light, and infrared light. As described above, the light emitting device 200 includes a plurality of light emitting surfaces, and the strongest light may be emitted toward an upper surface facing the light control member 500, which will be described later.

The light emitting device 200 may be a horizontal chip or a vertical chip. In the horizontal chip, two different electrodes may be disposed in a horizontal direction, and in the vertical chip, two different electrodes may be disposed in a vertical direction. Since the light emitting device 200 is connected to another chip or wiring pattern with a wire in the case of the horizontal type chip or the vertical type chip, the thickness of the module may increase due to the height of the wire and a pad space for bonding the wire is may be required. The light emitting device 200 is a device having a light emitting diode (LED) and may include a package in which a light emitting chip is packaged. The light emitting chip may emit at least one of visible light such as blue, red, green, and yellow, ultraviolet (UV), and infrared light, and the light emitting device 200 may emit at least one of visible light such as white, blue, red, yellow, and green, ultraviolet light, and infrared light. The light emitting device 200 may be a top view type in which the light emitting surface 201 faces upward. That is, the optical axis OA of the light emitting device 200 may be perpendicular to the upper surface of the substrate 100. A plurality of light emitting devices 200 may be disposed on the substrate 100. For example, a plurality of light emitting devices 200 spaced apart in a first direction (x-axis direction) may be disposed on the substrate 100. In addition, a plurality of light emitting devices 200 spaced apart in a second direction (y-axis direction) may be disposed on the substrate 100. In this case, the plurality of light emitting devices 200 may be spaced apart at intervals in the horizontal direction defined by the first pitch interval P1. Here, the first pitch interval P1 may mean an interval between centers of the plurality of light emitting devices 200. The plurality of light emitting devices 200 may emit light of the same color as each other. For example, the plurality of light emitting devices 200 may emit light of the same wavelength band toward the light control member 500. Alternatively, the plurality of light emitting devices 200 may emit light in different wavelength bands. For example, some of the plurality of light emitting devices 200 may emit light in a first wavelength band, and the rest or other parts may emit light in a second wavelength band different from the first wavelength band. Accordingly, the lighting device 1000 may provide light of various wavelength bands using one device.

The light emitting device 200 may include a light emitting surface 201 from which light is emitted. For example, when the light emitting device 200 emits light from five surfaces, the light emitting surface 201 may be an upper surface (a surface facing the light control member 500), which is a surface from which relatively strongest light is emitted. Also, when the light emitting device 200 is a top view type, the light emitting surface 201 may be an upper surface of the light emitting device 200 facing the light control member 500. That is, the light emitting surface 201 may mean a surface emitting light of the highest intensity toward the light control member 500. The light emitting surface 201 may be formed in a plane parallel to the reflective layer 300 and may include a concave surface or a convex surface. Light emitted from the light emitting device 200 may travel toward the upper surface of the resin layer 400. In addition, some of the emitted light may be reflected by the reflective layer 300 and proceed toward the upper surface of the resin layer 400.

The reflective layer 300 may be disposed on the substrate 100. The reflective layer 300 may be disposed between the substrate 100 and the resin layer 400. The reflective layer 300 may be provided in the form of a film having a metal material or a non-metal material. The reflective layer 300 may be adhered to the upper surface of the substrate 100. The reflective layer 300 may be adhered between the resin layer 400 and the substrate 100, but is not limited thereto. The reflective layer 300 may have an area smaller than that of the upper surface of the substrate 100. The reflective layer 300 may be spaced apart from an edge of the substrate 100. The resin layer 400 may be disposed in a region between the reflective layer 300 and the edge of the substrate 100 and attached to the substrate 100. Accordingly, peeling of the edge portion of the reflective layer 300 may be prevented.

The reflective layer 300 may include an opening portion 301 in which a lower portion of the light emitting device 200 is disposed. A portion in which the upper surface of the substrate 100 is exposed and the lower portion of the light emitting device 200 is bonded may be disposed in the opening portion 301 of the reflective layer 300. The size of the opening portion 301 may be equal to or larger than the size of the light emitting device 200, but is not limited thereto. The reflective layer 300 may be formed to a thickness smaller than that of the light emitting device 200. The thickness of the reflective layer 300 may include a range of 0.2 mm ±0.02 mm. The lower portion of the light emitting device 200 may be disposed on the substrate 100 through the opening portion 301 of the reflective layer 300, and the upper portion of the light emitting device 200 may protrude more than an upper surface of the opening portion 301. An emission surface of the light emitting device 200 may be provided in a direction perpendicular to the upper surface of the reflective layer 300.

The reflective layer 300 may include a metallic material or a non-metallic material. The metallic material may include a metal such as aluminum, silver, or gold. The non-metallic material may include a plastic material or a resin material. The plastic material may be any one selected from the group consisting of polyethylene, polypropylene, polystyrene, polyvinyl chloride, polybiphenyl chloride, polyethylene terephthalate, polyvinyl alcohol, polycarbonate, polybutylene terephthalate, polyethylene naphthalate, polyamide, polyacetal, polyphenylene, polyamideimide, polyetherimide, polyetheretherketone, polyimide, polytetrafluoroethylene, liquid crystal polymer, fluororesin, copolymers thereof, and mixtures thereof. As the resin material, a reflective material such as TiO₂, Al₂O₃, or SiO₂ may be added to silicon or epoxy. The reflective layer 300 may be implemented as a single layer or multiple layers, and light reflection efficiency may be improved by such a layer structure. The reflective layer 300 according to an embodiment of the invention may increase the amount of light so that the light is uniformly distributed by reflecting the incident light. Here, the reflective layer 300 may be omitted when a highly reflective material is coated on the upper surface of the substrate 100. As another example, the reflective layer 300 may include a plurality of reflectors (not shown). The reflector may be a bubble such as air or a medium having a refractive index equal to that of air. The reflective layer 300 may reflect light incident by the plurality of reflectors or refract it in a different direction.

The reflective layer 300 may include a reflective pattern 310. The reflective pattern 310 may have a plurality of dot shapes. A plurality of reflective patterns 310 may be disposed on an upper surface of the reflective layer 300. For example, the plurality of reflective patterns 310 may be disposed in a form protruding from the upper surface of the reflective layer 300. The plurality of reflective patterns 310 may be spaced apart from the light emitting device 200 and may be arranged to surround a lower portion of the light emitting device 200.

The plurality of reflective patterns 310 may be formed on the reflective layer 300 through printing. The plurality of reflective patterns 310 may include reflective ink. The plurality of reflective patterns 310 may be printed with a material including any one of TiO₂, CaCO₃, BaSO₄, Al₂O₃, Silicon, and PS. Each of the plurality of reflective patterns 310 may have a planar shape selected from among circular, elliptical, and polygonal shapes. Each of the plurality of reflective patterns 310 may have a hemispherical or a polygonal shape in a side cross section. A material of the plurality of reflective patterns 310 may be white. The dot pattern density of the reflective pattern 310 may increase as a distance from the light emitting device 200 increases. For example, a density of the dot pattern of the reflective pattern 310 per unit area may increase as a distance from the optical axis OA of the light emitting device 200 in the horizontal direction increases. The size of the plurality of reflective patterns 310 may change as a distance from the light emitting device 200 increases. For example, the width of the plurality of reflective patterns 310 in the horizontal direction may increase as a distance from the optical axis OA of the light emitting device 200 increases in the horizontal direction. That is, the plurality of reflective patterns 310 are disposed on a movement path of light emitted from the light emitting device 200 and/or a movement path of light emitted from the light emitting device 200 and reflected to other components to improve light reflectance and light loss can be reduced and luminance of the surface light source may be improved.

The resin layer 400 may be disposed on the substrate 100. The resin layer 400 may face the substrate 100. The resin layer 400 may be disposed on the entire upper surface or a partial region of the substrate 100. The resin layer 400 may seal the light emitting device 200 on the upper surface of the substrate 100. The resin layer 400 may contact side surfaces and upper surfaces of each of the light emitting devices 200. A lower surface area of the resin layer 400 may be equal to or greater than an upper surface area of the substrate 100. The resin layer 400 may be formed of a transparent material. The resin layer 400 may include a resin material such as silicone or epoxy. The resin layer 400 may include a thermosetting resin material, for example PC, OPS, PMMA, PVC, etc. may be selectively included. The resin layer 400 may be formed of glass, but is not limited thereto. For example, a resin material containing urethane acrylate oligomer as a main material may be used as the main material of the resin layer 400. For example, a mixture of a synthetic oligomer, urethane acrylate oligomer, and a polyacrylic polymer type may be used. Of course, it may further include a monomer mixed with low-boiling dilute reactive monomers such as IBOA (isobornyl acrylate), HPA (Hydroxylpropyl acrylate, 2-HEA (2-hydroxyethyl acrylate)), etc., and a photoinitiator (e.g., 1 -hydroxycyclohexyl phenyl-ketone, etc.) or antioxidants may be mixed.

Since the resin layer 400 is provided as a layer for guiding light with resin, it may be provided with a thinner thickness than glass and may be provided as a flexible plate. The resin layer 400 may emit point light emitted from the light emitting device 200 in the form of a linear light source or a surface light source. The upper surface of the resin layer 400 may emit light by diffusing light emitted from the light emitting device 200. For example, a bead (not shown) may be included in the resin layer 400, and the bead diffuses and reflects incident light to increase the amount of light. The beads may be disposed in a range of 0.01 to 0.3% based on the weight of the resin layer 400. The bead may be composed of any one selected from silicon, silica, glass bubble, PMMA (Polymethyl methacrylate), urethane, Zn, Zr, Al₂O₃, and acrylic, and the particle diameter of the bead may be in the range of about 1 µm to about 20 µm, but is not limited thereto. The linear light source is a type of light in which light emitted from one or more light emitting devices is emitted through at least one side surface of the resin layer 400, and the height or thickness of at least one side emitted may be 3 times or less or 2.5 times or less of the thickness of the light emitting device. The surface light source is a type of light in which light emitted from light emitting devices arranged with at least one light emitting device in a horizontal direction and at least one light emitting device in a vertical direction is emitted in an area several tens or hundreds of times larger than the area of an upper surface of the light emitting device.

Since the resin layer 400 is disposed on the light emitting device 200, the light emitting device 200 may be protected and loss of light emitted from the light emitting device 200 may be reduced. The light emitting device 200 may be buried under the resin layer 400. The resin layer 400 may contact the surface of the light emitting device 200 and may contact the emission surface of the light emitting device 200. A portion of the resin layer 400 may be disposed in the opening portion 301 of the reflective layer 300. A portion of the resin layer 400 may contact the upper surface of the substrate 100 through the opening portion 301 of the reflective layer 300. Accordingly, as a part of the resin layer 400 comes into contact with the substrate 100, the reflective layer 300 may be fixed between the resin layer 400 and the substrate 100.

The resin layer 400 may be formed to a thickness greater than that of the light emitting device 200. For example, the thickness h1 of the resin layer 400 may be about 1 mm or more. In detail, the thickness h1 of the resin layer 400 may be about 1 mm to about 10 mm. When the thickness h1 of the resin layer 400 is less than about 1 mm, light emitted from the light emitting device 200 may not be effectively guided. Accordingly, it may be difficult for the light source module 1000 to implement a uniform surface light source. In addition, when the thickness h1 of the resin layer 400 is less than about 1 mm, it may be difficult to effectively protect the light emitting device 200, and the adhesive force between the substrate 100 and the reflective layer 300 may be lowered. In addition, when the thickness of the resin layer 400 exceeds about 10 mm, light loss may occur due to an increase in the movement path of the light emitted from the light emitting device 200, and the luminance of the surface light may decrease. Accordingly, the thickness of the resin layer 400 may be within the above range to provide a uniform surface light. The vertical height from the upper surface of the resin layer 400 to the upper surface of the light emitting device 200 may be greater than the thickness of the light emitting device 200. For example, the height from the upper surface of the resin layer 400 to the upper surface of the light emitting device 200 may be about 3 times to about 15 times the thickness of the light emitting device 200. The thickness of the resin layer 400 and the thickness of the light emitting device 200 may satisfy the above ranges in order to effectively guide the point light emitted from the light emitting device 200 and emit it in the form of a linear light source or a surface light source.

The light control member 500 may be disposed on the resin layer 400. The light control member 500 may be disposed on an upper surface of the resin layer 400. The light control member 500 may include a first substrate 511, a second substrate 512 and a first adhesive member 531. The first substrate 511 may be disposed on an upper surface of the resin layer 400. The first substrate 511 may be disposed on the entire upper surface of the resin layer 400. The lower surface area of the first substrate 511 may be the same as the upper surface area of the resin layer 400. The lower surface of the first substrate 511 may come into contact with the upper surface of the resin layer 400. The first substrate 511 may include a light-transmissive material. For example, the first substrate 511 may include at least one of polyethylene terephthalate (PET), polystyrene (PS), polyimide (PI), polyethylene naphthalate (PEN), and polycarbonate (PC). The first substrate 511 may have a set thickness. For example, the thickness of the first substrate 511 may be about 150 µm or less. In detail, the thickness of the first substrate 511 may be about 100 µm or less. In more detail, the thickness of the first substrate 511 may be about 20 µm to about 100 µm. The first substrate 511 may be provided in the form of a light-transmissive film having a set thickness. The first substrate 511 may be a first light-transmissive film disposed on the upper surface of the resin layer 400.

The second substrate 512 may be disposed on an upper surface of the first substrate 511. The second substrate 512 may include a light-transmissive material. For example, the second substrate 512 may include at least one of polyethylene terephthalate (PET), polystyrene (PS), polyimide (PI), polyethylene naphthalate (PEN), and polycarbonate (PC). The second substrate 512 may be a second light-transmissive film disposed on the first substrate 511 or the first light-transmissive film. The second substrate 512 may be provided with the same material as the first substrate 511. For example, the first and second light-transmissive films may be formed of the same material. The second substrate 512 may have a set thickness. For example, the second substrate 512 may have a thickness of about 150 µm or less. In detail, the second substrate 512 may have a thickness of about 100 µm or less. In more detail, the second substrate 512 may have a thickness of about 20 µm to about 100 µm. The second substrate 512 may be provided in the form of a light-transmissive film having a set thickness. The second substrate 512 may be provided with the same thickness as the first substrate 511. For example, the first and second light-transmissive films may have the same thickness.

The first adhesive member 531 may be disposed between the first substrate 511 and the second substrate 512. The first adhesive member 531 may be an adhesive layer for bonding the first substrate 511 and the second substrate 512. The first adhesive member 531 may be formed of a light-transmissive material. For example, the first adhesive member 531 may include an adhesive material such as thermosetting PSA, thermosetting adhesive, UV curing PSA, UV adhesive, silicone, or epoxy. The first adhesive member 531 may be disposed in a set region. For example, the first adhesive member 531 is disposed in a partial region among regions between the first substrate 511 and the second substrate 512, and the first air gap 551 may be formed in the remaining region where the first adhesive member 531 is not disposed. The first air gap 551 may be a region surrounded by the first adhesive member 531 in a region between the first substrate 511 and the second substrate 512. The first air gap 551 may have a hole shape extending between the first substrate 511 and the second substrate 512. The first air gap 551 is formed as an air layer or a vacuum layer, and at least one or a plurality of first air gaps 551 may be disposed in a region between the first substrate 511 and the second substrate 512.

The first air gap 551 may form a first reflective surface 531S. The first reflective surface 531S may be a side surface of the first adhesive member 531. In detail, the first reflective surface 531S may be a side surface of the first adhesive member 531 exposed by the first air gap 551. The first reflective surface 531S may be perpendicular to the upper surface of the first substrate 511. Alternatively, the first reflective surface 531S may be disposed inclined to have a predetermined inclination angle with the upper surface of the first substrate 511. The first reflective surface 531S may reflect light incident to a surface formed by a difference in refractive index between the first air gap 551 and the first adhesive member 531. Accordingly, the light control member 500 refracts and reflects the light emitted from the light emitting device 200 in a set direction, thereby preventing a hot spot phenomenon in which light is concentrated.

The number of first air gaps 551 may be greater than the number of light emitting devices 200. That is, one light emitting device 200 may correspond to a plurality of first air gaps 551. The plurality of first air gaps 551 may be spaced apart from each other in a region between the first substrate 511 and the second substrate 512. In this case, the plurality of first air gaps 551 may be spaced at regular intervals, and the distance between the plurality of first air gaps 551 may be about 0.1 mm to about 1 mm. The plurality of first air gaps 551 may have a set shape. For example, when viewing the first air gap 551 from the top, the first air gap 551 may have various shapes such as a polygon, a circle, and an ellipse. The plurality of first air gaps 551 may have the same shape as each other. For example, the top shape of the plurality of first air gaps 551 may be circular as shown in FIG. 3. The plurality of first air gaps 551 may have a set width. For example, the width of the first air gap 551 in the horizontal direction (x-axis or y-axis direction) may be smaller than the width d1 of the light emitting device 200 in the horizontal direction. For example, the horizontal width of the first air gap 551 may be about 0.1 mm to about 1 mm. The plurality of first air gaps 551 may have the same horizontal width as each other. Also, each of the plurality of first air gaps 551 may have a constant width. For example, the widths of the plurality of first air gaps 551 may have a constant width without changing from the first substrate 511 toward the second substrate 512. That is, the cross-sectional shape of the first air gap 551 may be a rectangular shape with a constant width. The plurality of first air gaps 551 may be disposed at set positions. In detail, the plurality of first air gaps 551 may be disposed in a region corresponding to the light emitting device 200. For example, a portion of the plurality of first air gaps 551 in the vertical direction (z-axis direction) may be disposed in a region overlapping the light emitting device 200. In addition, the remaining region of the plurality of first air gaps 551 may be disposed in a region that does not overlap with the light emitting device 200. A region where the plurality of first air gaps 551 are disposed may be defined as a first region R1. Here, the first region R1 may be a region in which a plurality of first air gaps 551 matching one light emitting device 200 are disposed. As an example, the first region R1 may refer to a region in which the outer sides of the plurality of first air gaps 551 located at the outermost part of FIG. 3 are connected in a straight line.

The first region R1 may have a set size. For example, when the light emitting device 200 includes an LED chip emitting light on five sides or is a top view type in which the light emitting surface 201 faces upward, a second width d2 defined as the first direction width of the first region R1 may be about 2 to about 10 times the first direction width of the light emitting device 200. In detail, the second width d2 may be about 3 to about 6 times the width of the light emitting device 200 in the first direction. Also, the third width d3 defined as the width of the first region R1 in the second direction may be about 2 to about 10 times the width of the light emitting device 200 in the second direction. In detail, the third width d3 may be about 3 to about 6 times the width of the light emitting device 200 in the second direction. The first regions R1 may be spaced apart at a second pitch interval P2 based on the horizontal direction. Here, the second pitch interval P2 may be the shortest interval between horizontally adjacent first regions R1. The second pitch interval P2 may be smaller than the first pitch interval P1 of the light emitting devices 200.

When the width of the first air gap 551, the interval between the first air gaps 551, the position of the first region R1, and the size of the first region R1 do not satisfy the above-described range compared to the light emitting device 200, it may be difficult to prevent hot spots from being formed by the light emitted from the light emitting device 200. In detail, when the size of the first region R1 is smaller than the described range, a hot spot may be formed because the area for preventing hot spots from being formed is relatively small. In addition, when the size of the first region R1 exceeds the above range, the areas occupied by the first adhesive member 531 and the first air gap 551 is relatively large, and thus the light transmittance due to the above components may be reduced. Therefore, it is desirable that the size of the first region R1 formed by the plurality of first air gaps 551 is satisfied in order to effectively prevent hot spots from being formed and to minimize light transmittance degradation caused by the first air gap 551.

The lighting device 1000 may include a light blocking member 570. The light blocking member 570 may be disposed on the light control member 500. The light blocking member 570 may be disposed between the first substrate 511 and the second substrate 512. The light blocking member 570 may be disposed on a lower surface of the second substrate 512 facing the first substrate 511. The light blocking member 570 may be disposed between the second substrate 512 and the first adhesive member 531. Also, the light blocking member 570 may be disposed between the second substrate 512 and the plurality of first air gaps 551. The light blocking member 570 may be overlapped and printed in a plurality of layers on the lower surface of the second substrate 512. Also, the light blocking member 570 may have a structure including a plurality of patterns having different sizes. When the light blocking member 570 is viewed from above, the planar shape of the light blocking member 570 may have various shapes such as a circular shape, an elliptical shape, and a polygonal shape. For example, the planar shape of the light blocking member 570 may include a curved shape in consideration of an angle of view of the light emitting device 200. The light blocking members 570 are provided in the same number as the light emitting devices 200 and may be disposed in a region overlapping the light emitting devices 200 in a third direction (z-axis direction). Also, a portion of the light blocking member 570 may be disposed in a region overlapping a portion of the plurality of first air gaps 551 in the third direction. The light blocking member 570 may have a shape extending in a horizontal direction. The light blocking member 570 may have a fourth width d4 defined as a first direction width, and the fourth width d4 may be larger than the first direction width d1 of the light emitting device 200 and the horizontal width of the first air gap 551, and may be smaller than the second width d2 of the first region R1. In addition, the light blocking member 570 has a fifth width d5 defined as a second direction width, and the fifth width d5 may be greater than the second direction width of the light emitting device 200 and less than the third width d3 of the first region R1.

The lighting device 1000 according to the embodiment of the invention may include a plurality of first air gaps 551 matching one light emitting device 200, and each of the plurality of first air gaps 551 may have a width smaller than that of the light emitting device 200. Accordingly, according to the embodiment, it is possible to prevent a hot spot in which light is concentrated by the light emitted from the light emitting device 200 from being formed. Specifically, light incident on the light control member 500 may be reflected and refracted by the first adhesive member 531, the first air gap 551, and the first reflective surface 531S to change the emission direction, thereby preventing the light of the light emitting device 200 from being concentrated. The lighting device 1000 according to the embodiment of the invention further includes the light blocking member 570 to more effectively prevent hot spots where light is concentrated from being formed. The lighting device 1000 may minimize the area or/and size of the light blocking member 570 formed by the first air gap 551, thereby minimizing light loss due to the light blocking member 570. Accordingly, the lighting device 1000 according to the embodiment may implement a uniform linear light source or a surface light source with improved luminance. Also, since the lighting device 1000 forms a plurality of first air gaps 551 on one adhesive member, the light control member 500 may have a smaller thickness.

### <Second Embodiment>

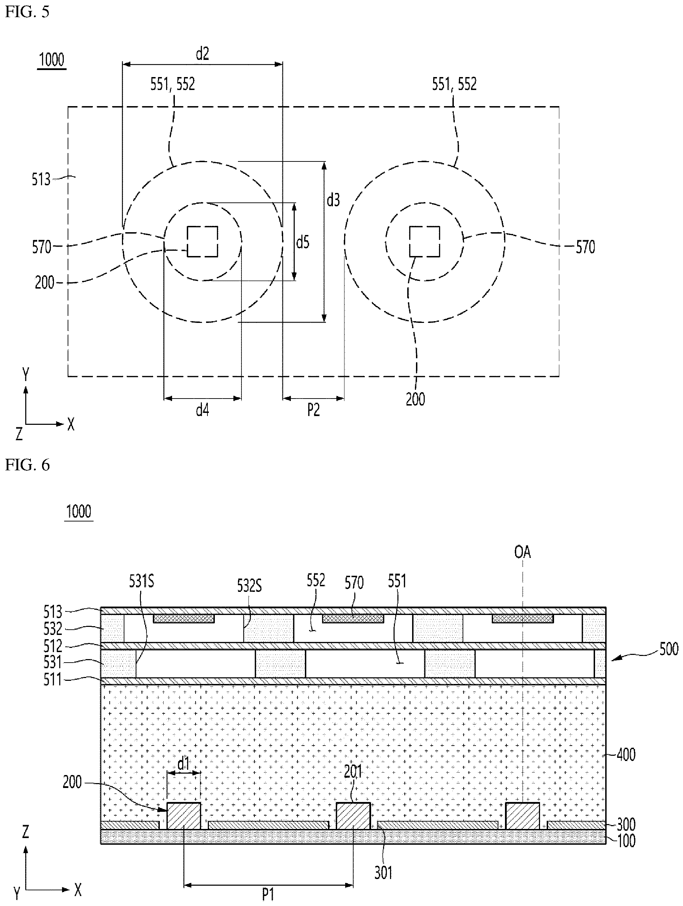

FIG. 4 is a side cross-sectional view of a lighting device according to a second embodiment of the present invention, and FIG. 5 is a top view of the lighting device of FIG. 4. In the description using FIGs. 4 and 5, descriptions of components identical or similar to those of the above-described lighting device are omitted and the same reference numerals are assigned, and may be selectively applied to the present embodiment.

Referring to FIGs 4 and 5, the lighting device 1000 according to the second embodiment of the invention may include a light emitting device 200 and a light control member 500 disposed on the resin layer 400. The light emitting device 200 may include an LED chip emitting light on five sides or may include a top view type in which the light emitting surface 201 faces upward. The light control member 500 is disposed on the upper surface of the resin layer 400 and may include the first substrate 511, the second substrate 512, the first adhesive member 531, a third substrate 513 and a second adhesive member 532. The first adhesive member 531 may be disposed between the first substrate 511 and the second substrate 512. The first adhesive member 531 may be an adhesive layer that adheres the first substrate 511 and the second substrate 512 together.

The first adhesive member 531 may be disposed in a set area. For example, the first adhesive member 531 may be disposed in a partial region between the first substrate 511 and the second substrate 512, and a first air gap 551 may be formed in the remaining region where the first adhesive member 531 is not disposed. The first air gap 551 may be a region surrounded by the first adhesive member 531 in a region between the first substrate 511 and the second substrate 512. The first air gap 551 may have a hole shape extending between the first substrate 511 and the second substrate 512. The first air gap 551 is formed as an air layer or a vacuum layer, and at least one may be disposed in a region between the first substrate 511 and the second substrate 512. The first air gap 551 may form a first reflective surface 531S. The first reflective surface 531S may be a side surface of the first adhesive member 531. In detail, the first reflective surface 531S may be a side surface of the first adhesive member 531 exposed by the first air gap 551. The first reflective surface 531S may be perpendicular to the upper surface of the first substrate 511. Alternatively, the first reflective surface 531S may be disposed inclined to have a predetermined inclination angle with the upper surface of the first substrate 511. The first reflective surface 531S may reflect light incident to a surface formed by a difference in refractive index between the first air gap 551 and the first adhesive member 531. Accordingly, the light control member 500 refracts and reflects the light emitted from the light emitting device 200 in a set direction, thereby preventing a hot spot phenomenon in which light is concentrated.

The number of first air gaps 551 equal to the number of the plurality of light emitting devices 200 may be provided. That is, the plurality of first air gaps 551 may be arranged and matched with the plurality of light emitting devices 200 one-to-one. The plurality of first air gaps 551 may be spaced apart from each other in a region between the first substrate 511 and the second substrate 512. In this case, the plurality of first air gaps 551 may be spaced apart from each other at equal intervals. For example, the distance between the plurality of first air gaps 551 may be about 0.1 mm to about 1 mm. The first air gap 551 may be disposed at a set position. For example, the first air gap 551 may be disposed in a region corresponding to the light emitting device 200. In detail, the first air gap 551 may be disposed in a region overlapping in a vertical direction with the optical axis OA of the light emitting device 200 that matches the center of the first air gap 551. The plurality of first air gaps 551 may have a set shape. For example, when viewing the first air gap 551 from the top, the first air gap 551 may have various shapes such as a polygon, a circle, and an ellipse. The plurality of first air gaps 551 may have the same shape as each other. For example, the top shape of the plurality of first air gaps 551 may be circular as shown in FIG. 5. The plurality of first air gaps 551 may have a set width. For example, the width of the first air gap 551 in the horizontal direction (x-axis or y-axis direction) may be greater than the width d1 of the light emitting device 200 in the horizontal direction. The plurality of first air gaps 551 may have the same horizontal width as each other. Also, each of the plurality of first air gaps 551 may have a constant width. For example, the widths of the plurality of first air gaps 551 may have a constant width without changing from the first substrate 511 toward the second substrate 512. That is, the cross-sectional shape of the first air gap 551 may be a rectangular shape with a constant width as shown in FIG. 4.

The first air gap 551 may have widths in first and second directions. For example, the second width d2 defined as the first direction width of the first air gap 551 may be about 2 to about 10 times the first direction width d1 of the light emitting device 200. In detail, the second width d2 may be about 3 to about 6 times the width d1 of the light emitting device 200 in the first direction. Also, the third width d3 defined as the width of the first air gap 551 in the second direction may be about 2 to about 10 times the width of the light emitting device 200 in the second direction. In detail, the third width d3 may be about 3 to about 6 times the width of the light emitting device 200 in the second direction. The first air gaps 551 may be spaced apart at a second pitch interval P2 based on the horizontal direction. Here, the second pitch interval P2 may be the shortest interval between horizontally adjacent first air gaps 551. The second pitch interval P2 may be smaller than the first pitch interval P1 of the light emitting devices 200.

The third substrate 513 may be disposed on the second substrate 512. The third substrate 513 may be disposed on the upper surface of the second substrate 512. The third substrate 513 may include a light-transmissive material. For example, the third substrate 513 may include at least one of polyethylene terephthalate (PET), polystyrene (PS), polyimide (PI), polyethylene naphthalate (PEN), and polycarbonate (PC). The third substrate 513 may be provided with the same material as the first substrate 511 and the second substrate 512. The third substrate 513 may be a third light-transmissive film disposed on the second light-transmissive film. The first, second, and third light-transmissive films may be made of the same material. The first, second, and third light-transmissive films may have the same area as each other. The third substrate 513 may have a set thickness. For example, the thickness of the third substrate 513 may be about 150 µm or less. In detail, the thickness of the third substrate 513 may be about 100 µm or less. In more detail, the third substrate 513 may have a thickness of about 20 µm to about 100 µm. The third substrate 513 may be provided in the form of a light-transmissive film having a set thickness. In addition, the third substrate 513 may be provided with the same thickness as the first substrate 511 and the second substrate 512. The first, second, and third light-transmissive films may have the same thickness as each other.

The second adhesive member 532 may be disposed between the second substrate 512 and the third substrate 513. The second adhesive member 532 may be an adhesive layer that adheres the second substrate 512 and the third substrate 513 together. The second adhesive member 532 may be formed of a light-transmissive material. For example, the second adhesive member 532 may include an adhesive material such as thermosetting PSA, thermosetting adhesive, UV curing PSA, UV adhesive, silicone, or epoxy. The second adhesive member 532 may be disposed in a set region. For example, the second adhesive member 532 may be disposed in some regions between the second substrate 512 and the third substrate 513, and a second air gap 552 may be formed in the remaining regions where the second adhesive member 532 is not disposed. The second air gap 552 may be a region surrounded by the second adhesive member 532 in a region between the second substrate 512 and the third substrate 513. The second air gap 552 may have a hole shape extending between the second substrate 512 and the third substrate 513. The second air gap 552 is formed as an air layer or a vacuum layer, and at least one of the second air gaps 552 may be disposed in a region between the second substrate 512 and the third substrate 513. The second air gap 552 may form a second reflective surface 532S. The second reflective surface 532S may be a side surface of the second adhesive member 532. In detail, the second reflective surface 532S may be a side surface of the second adhesive member 532 exposed by the second air gap 552. The second reflective surface 532S may be perpendicular to the upper surface of the second substrate 512. Alternatively, the second reflective surface 532S may be disposed inclined to have a predetermined inclination angle with the upper surface of the second substrate 512. The second reflective surface 532S may reflect light incident to a surface formed by a difference in refractive index between the second air gap 552 and the second adhesive member 532. The second reflective surface 532S may be parallel to the first reflective surface 531S. In detail, the second reflective surface 532S may be disposed on the same plane as the first reflective surface 531S. Accordingly, the light control member 500 refracts and reflects the light emitted from the light emitting device 200 in a set direction, thereby preventing a hot spot phenomenon in which light is concentrated.

The second air gaps 552 may be provided in plural numbers equal to the number of the plurality of light emitting devices 200 and the plurality of first air gaps 551. That is, the plurality of second air gaps 552 may be matched one-to-one with the plurality of light emitting devices 200 and the plurality of first air gaps 551 and disposed. The plurality of second air gaps 552 may be spaced apart from each other in a region between the second substrate 512 and the third substrate 513. In this case, the plurality of second air gaps 552 may be spaced apart from each other at equal intervals. For example, a distance between the plurality of second air gaps 552 may be about 0.1 mm to about 1 mm. The second air gap 552 may be disposed at a set position. For example, the second air gap 552 may be disposed in a region corresponding to the light emitting device 200 and the first air gap 551. In detail, the second air gap 552 may be disposed in a region overlapping in a vertical direction with the center of the first air gap 551 and the optical axis OA of the light emitting device 200 that matches the center of the second air gap 552. The second air gap 552 may have a set shape. For example, when viewing the second air gap 552 from the top, the second air gap 552 may have various shapes such as a polygonal shape, a circular shape, and an elliptical shape. The plurality of second air gaps 552 may have the same shape as each other. Also, the second air gap 552 may have the same shape as the first air gap 551. For example, the top shape of the plurality of second air gaps 552 may be circular as shown in FIG. 5.

The plurality of second air gaps 552 may have a set width. For example, the width of the second air gap 552 in the horizontal direction (x-axis or y-axis direction) may be greater than the width d1 of the light emitting device 200 in the horizontal direction. The plurality of second air gaps 552 may have the same horizontal width as each other. Also, each of the plurality of second air gaps 552 may have a constant width. For example, the widths of the plurality of second air gaps 552 may have a constant width without changing from the second substrate 512 toward the third substrate 513. That is, the cross-sectional shape of the second air gap 552 may be a rectangular shape with a constant width as shown in FIG. 4. The second air gap 552 may have widths in first and second directions. For example, the second air gap 552 may have the same widths as the first air gap 551 in the first and second directions. Specifically, the second width d2 defined as the first direction width of the second air gap 552 may be the same as the second width d2 of the first air gap 551, and may be about 2 to about 10 times the first direction width of the light emitting device 200. In detail, the second width d2 of the second air gap 552 may be about 3 to about 6 times the width of the light emitting device 200 in the first direction. In addition, the third width d3 defined as the second direction width of the second air gap 552 may be the same as the third width d3 of the first air gap 551, and may be about 2 to about 10 times the second direction width of the light emitting device 200. In detail, the third width d3 of the second air gap 552 may be about 3 to about 6 times the width of the light emitting device 200 in the second direction. The second air gaps 552 may be spaced apart by the second pitch interval P2 based on the horizontal direction. Here, the second pitch interval P2 may be the shortest interval of the horizontally adjacent second air gaps 552. The second pitch interval P2 of the second air gap 552 may be the same as the second pitch interval P2 of the first air gap 551, and may be smaller than the first pitch interval P1 of the light emitting devices 200.

The lighting device 1000 may include a light blocking member 570. The light blocking member 570 may be disposed on the light control member 500. The light blocking member 570 may be disposed on an outermost substrate among the plurality of substrates 511, 512, and 513. That is, the light blocking member 570 may be disposed on the third substrate 513. The light blocking member 570 may be disposed on a lower surface of the third substrate 513 facing the second substrate 512. The light blocking member 570 may be disposed between the third substrate 513 and the second air gap 552. The light blocking member 570 may be overlapped and printed in a plurality of layers. Also, the light blocking member 570 may have a structure including a plurality of patterns having different sizes. When the light blocking member 570 is viewed from above, the planar shape of the light blocking member 570 may have various shapes such as a circular shape, an elliptical shape, and a polygonal shape. For example, the planar shape of the light blocking member 570 may include a curved shape in consideration of an angle of view of the light emitting device 200.

The light blocking members 570 are provided in the same number as the light emitting devices 200 and may be disposed in a region overlapping the light emitting devices 200 in a third direction. In addition, the light blocking member 570 may be provided in the same number as the first air gap 551 and the second air gap 552, and may be disposed in a region overlapping the first air gap 551 and the second air gap 552 in a third direction. The center of the light blocking member 570 may overlap the center of the first air gap 551 and the center of the second air gap 552 in a third direction, and may overlap the optical axis OA of the light emitting device 200. The light blocking member 570 may have a shape extending in a horizontal direction. The light blocking member 570 may have a fourth width d4 defined as a first direction width, and the fourth width d4 may be greater than the first direction width d1 of the light emitting device 200 and may be smaller than the second width d2 of the first and second air gaps 551 and 552. In addition, the light blocking member 570 has a fifth width d5 defined as a second direction width, and the fifth width d5 may be larger than the second direction width of the light emitting device 200, and may be smaller than the third width d3 of the first and second air gaps 551 and 552.

In the lighting device 1000 according to the second embodiment of the invention, a plurality of air gaps matching them, such as the first air gap 551 and the second air gap 552, may be formed in a multilayer structure on one light emitting device 200. In this case, the first air gap 551 and the second air gap 552 are provided with a horizontal width greater than that of the light emitting device 200, and may have the same shape and horizontal width. In addition, the first air gap 551 and the second air gap 552 are disposed in overlapping regions, and their centers may overlap the optical axis OA of the light emitting device 200. Due to this, it is possible to prevent a hot spot from being formed by light emitted from the light emitting device 200. In detail, the light control member 500 may control the emission direction by refracting and reflecting the incident light, and may prevent the light from the light emitting device 200 from being concentrated. The light control member 500 may minimize the area and size of the formed light blocking member 570, thereby minimizing light loss due to the light blocking control member 500. Accordingly, the lighting device 1000 according to the embodiment may implement a uniform linear light source or a surface light source with improved luminance. Further, the lighting device 1000 may have a thinner thickness, may have flexibility, and may be provided in various shapes such as a straight line or a curved line.

FIG. 6 is another cross-sectional view of a lighting device according to a second embodiment. In the description using FIG. 6, descriptions of components identical or similar to those of the lighting device described above are omitted and the same reference numerals are assigned, and may be selectively applied to the present embodiment.

Referring to FIG. 6, the light control member 500 may include the first substrate 511, the second substrate 512, the first adhesive member 531, a first air gap 551, a third substrate 513, a second adhesive member 532, and a light blocking member 570. Each of the first air gap 551 and the second air gap 552 may be provided in a plurality equal to the number of the plurality of light emitting devices 200. That is, each of the plurality of first air gaps 551 and the plurality of second air gaps 552 may be matched with the plurality of light emitting devices 200 one-to-one and arranged. The first air gap 551 and the second air gap 552 may have the same shape. For example, the first air gap 551 and the second air gap 552 may have various upper shapes such as a polygonal shape, a circular shape, and an elliptical shape. The first air gap 551 and the second air gap 552 may have the same horizontal width. In detail, the second width d2 of each of the first air gap 551 and the second air gap 552 may be about 2 to about 10 times the first direction width d1 of the light emitting device 200. Also, the third width d3 of each of the first air gap 551 and the second air gap 552 may be about 2 to about 10 times the width of the light emitting device 200 in the second direction. Also, the widths of the first air gap 551 and the second air gap 552 may be constant from bottom to top without changing. That is, cross-sectional shapes of the first air gap 551 and the second air gap 552 may have a rectangular shape with a constant width as shown in FIG. 6. The plurality of first air gaps 551 may be spaced apart from each other by the second pitch interval P2 based on the horizontal direction, and the plurality of second air gaps 552 may be spaced apart from each other by the second pitch interval P2. The first air gap 551 and the second air gap 552 may be disposed at set positions. For example, the first air gap 551 and the second air gap 552 may be disposed in regions corresponding to the light emitting device 200. In this case, the first air gap 551 and the second air gap 552 may be arranged in a zigzag shape. The first air gap 551 and the second air gap 552 may partially overlap each other. In detail, the first air gap 551 may be disposed in a region where the center of the first air gap 551 does not overlap the optical axis of the light emitting device 200 within a range overlapping the light emitting device 200 in a vertical direction. That is, the center of the first air gap 551 may be disposed in an area horizontally spaced apart from the optical axis OA of the light emitting device 200. Also, the center of the second air gap 552 may be disposed in a region overlapping the optical axis OA of the light emitting device 200. Accordingly, the first reflective surface 531S and the second reflective surface 532S may not be disposed on the same plane but may be disposed stepwise.

The light blocking member 570 may be disposed on an outermost substrate among the plurality of substrates 511, 512, and 513. The light blocking member 570 may be disposed on a lower surface of the third substrate 513. The light blocking member 570 may be provided in the same number as the light emitting device 200, the first air gap 551, and the second air gap 552. In addition, the center of the light blocking member 570 may be disposed in a region overlapping the optical axis OA of the light emitting device 200 and the center of the second air gap 552 in a third direction, and may not overlap the center of the first air gap 551.

In another example of the lighting device 1000 according to the second embodiment of the invention, a plurality of air gaps, for example, the first air gap 551 and the second air gap 552, may be formed on one light emitting device 200. In this case, the second air gap 552 disposed on the outermost side of the multilayer air gap may be disposed so that the center thereof coincides with the optical axis of the light emitting device 200, and a center of the first air gap 551 disposed under a lower portion of the second air gap 552 may be disposed such that the optical axis OA and the center of the second air gap 552 do not overlap. Accordingly, it is possible to more effectively prevent hot spots from being formed by light emitted from the light emitting device 200. In detail, the first air gap 551 and the second air gap 552 according to the embodiment are arranged in a zigzag form, and the positions of the first reflective surface 531S and the second reflective surface 532S may be controlled by controlling the degree to which the center of the first air gap 551 is spaced apart from the optical axis OA. Accordingly, it is possible to control the reflection angle of the light incident on the light control member 500, so that the emission direction may be controlled in more various ways. Accordingly, the lighting device 1000 according to the embodiment may have improved luminance and effectively control the formation of hot spots to implement a uniform linear light source or a surface light source.

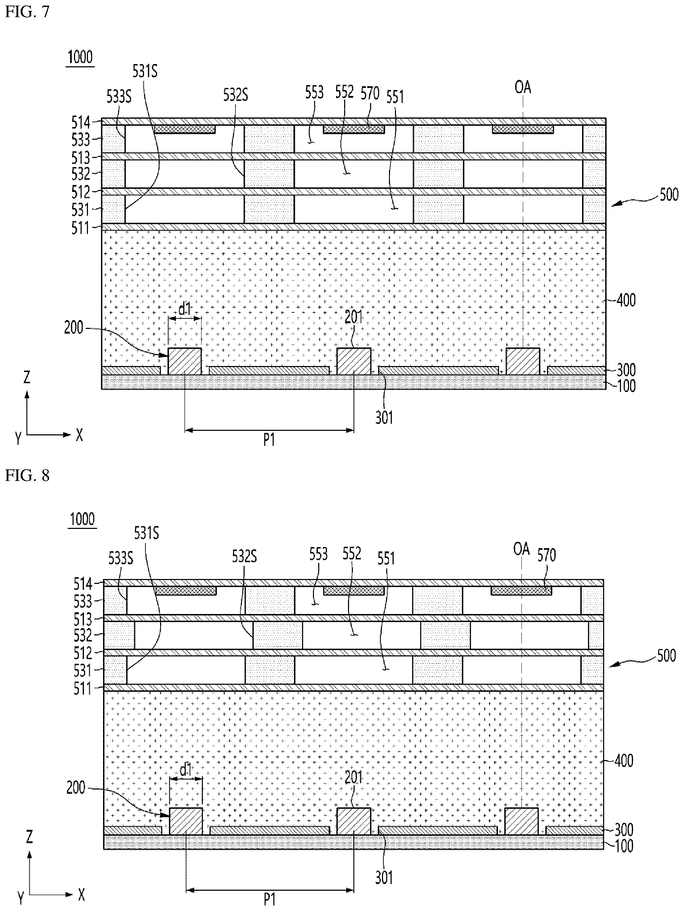

FIG. 7 is another cross-sectional view of a lighting device according to a second embodiment. In the description using FIG. 7, descriptions of components identical or similar to those of the lighting device described above are omitted and the same reference numerals are assigned, and may be selectively applied to the present embodiment.

Referring to FIG. 7, the lighting device 1000 according to the embodiment may have multiple air gaps than the lighting device 1000 according to FIG. 4. In detail, the light control member 500 may further include a fourth substrate 514 and a third adhesive member 533. The fourth substrate 514 may be disposed on the third substrate 513. The fourth substrate 514 may be disposed on an upper surface of the third substrate 513. The fourth substrate 514 may include a light-transmissive material. For example, the fourth substrate 514 may include at least one of polyethylene terephthalate (PET), polystyrene (PS), polyimide (PI), polyethylene naphthalate (PEN), and polycarbonate (PC). The fourth substrate 514 may be provided with the same material as the first substrate 511, the second substrate 512, and the third substrate 513. The fourth substrate 514 may be a fourth light-transmissive film disposed on the third light-transmissive film. The first to fourth light-transmissive films serving as the first to fourth substrates 511, 512, 513, and 514 may be made of the same material. Upper or lower surfaces of the first to fourth light-transmissive films may have the same area as each other. The fourth substrate 514 may have a set thickness. For example, the thickness of the fourth substrate 514 may be about 150 µm or less. In detail, the thickness of the fourth substrate 514 may be about 100 µm or less. In more detail, the fourth substrate 514 may have a thickness of about 20 µm to about 100 µm. The fourth substrate 514 may be provided in the form of a light-transmissive film having a set thickness. In addition, the fourth substrate 514 may be provided with the same thickness as the first substrate 511, the second substrate 512, and the third substrate 513. The first to fourth light-transmissive films may have the same thickness as each other.

A third adhesive member 533 may be disposed between the third substrate 513 and the fourth substrate 514. The third adhesive member 533 may be an adhesive layer that adheres the third substrate 513 and the fourth substrate 514 together. The third adhesive member 533 may be formed of a light-transmissive material. For example, the third adhesive member 533 may include an adhesive material such as thermosetting PSA, thermosetting adhesive, UV curing PSA, UV adhesive, silicone, or epoxy. The third adhesive member 533 may be disposed in a set region. For example, the third adhesive member 533 may be disposed in some regions between the third substrate 513 and the fourth substrate 514, and a third air gap 553 may be formed in the remaining regions where the third adhesive member 533 is not disposed. The third air gap 553 may be a region between the third substrate 513 and the fourth substrate 514 and surrounded by the third adhesive member 533. The third air gap 553 may have a hole shape extending between the third substrate 513 and the fourth substrate 514. The third air gap 553 is formed as an air layer or a vacuum layer, and at least one of the third air gaps 553 may be disposed in a region between the third substrate 513 and the fourth substrate 514. The third air gap 553 may form a third reflective surface 533S. The third reflective surface 533S may be a side surface of the third adhesive member 533. In detail, the third reflective surface 533S may be a side surface of the third adhesive member 533 exposed by the third air gap 553. The third reflective surface 533S may be perpendicular to the upper surface of the third substrate 513. Alternatively, the third reflective surface 533S may be disposed inclined to have a predetermined inclination angle with the upper surface of the third substrate 513. The third reflective surface 533S may reflect light incident to a surface formed by a difference in refractive index between the third air gap 553 and the third adhesive member 533. Accordingly, the light control member 500 refracts and reflects the light emitted from the light emitting device 200 in a set direction, thereby preventing a hot spot phenomenon in which light is concentrated.

The third air gaps 553 may be provided in a plurality equal to the number of the plurality of light emitting devices 200, the plurality of first air gaps 551, and the plurality of second air gaps 552. That is, the plurality of third air gaps 553 may be arranged in a one-to-one match with the plurality of light emitting devices 200, the plurality of first air gaps 551, and the plurality of second air gaps 552. The plurality of third air gaps 553 may be spaced apart from each other in a region between the third substrate 513 and the fourth substrate 514. In this case, the plurality of third air gaps 553 may be spaced apart from each other at equal intervals. For example, an interval between the plurality of third air gaps 553 may be about 0.1 mm to about 1 mm. The third air gap 553 may be disposed at a set position. For example, the third air gap 553 may be disposed in a region corresponding to the light emitting device 200, the first air gap 551, and the first air gap 551. In detail, the third air gap 553 may be disposed in a region vertically overlapping with the optical axis OA of the light emitting device 200 that matches the center of the third air gap 553, and the centers of the first air gap 551 and the second air gap 552. The third air gap 553 may have a set shape. For example, when viewing the third air gap 553 from the top, the third air gap 553 may have various shapes such as a polygon, a circle, and an ellipse. The plurality of third air gaps 553 may have the same shape as each other. Also, the third air gap 553 may have the same shape as the first air gap 551 and the second air gap 552. The plurality of third air gaps 553 may have a set width. For example, the width of the third air gap 553 in the horizontal direction (x-axis or y-axis direction) may be greater than the width d1 of the light emitting device 200 in the horizontal direction. The plurality of third air gaps 553 may have the same horizontal width as each other. Also, each of the plurality of third air gaps 553 may have a constant width. For example, the widths of the plurality of third air gaps 553 may have a constant width without changing from the third substrate 513 toward the fourth substrate 514. That is, the cross-sectional shape of the third air gap 553 may be a rectangular shape with a constant width as shown in FIG. 7. The third air gap 553 may have widths in first and second directions. For example, the third air gap 553 may have the same widths as the first and second air gaps 551 and 552 in the first and second directions. In detail, the second width d2 defined as the first direction width of the third air gap 553 may be the same as the second width d2 of the first air gap 551 and the second air gap 552, and may be about 2 to about 10 times the first direction width of the light emitting device 200. In detail, the second width d2 of the third air gap 553 may be about 3 to about 6 times the width of the light emitting device 200 in the first direction. In addition, the third width d3 defined as the second direction width of the third air gap 553 may be the same as the third width d3 of the first air gap 551 and the second air gap 552, and may be about twice to about 10 times the second direction width of the light emitting device 200. In detail, the third width d3 of the third air gap 553 may be about 3 to about 6 times the width of the light emitting device 200 in the second direction. The third air gaps 553 may be spaced apart from each other by the second pitch interval P2 based on the horizontal direction. Here, the second pitch interval P2 may be the shortest interval between the horizontally adjacent third air gaps 553. The second pitch interval P2 of the third air gap 553 may be the same as the second pitch interval P2 of the first air gap 551 and the second air gap 552, and may be smaller than the first pitch interval P1 of the light emitting devices 200.

The lighting device 1000 may include a light blocking member 570. The light blocking member 570 may be disposed on an outermost substrate among the plurality of substrates 511, 512, 513, and 514. The light blocking member 570 may be disposed on the lower surface of the fourth substrate 514. The light blocking member 570 may be disposed between the fourth substrate 514 and the third air gap 553. The light blocking member 570 may be provided in the same number as the light emitting device 200, the first air gap 551, the second air gap 552, and the third air gap 553. In addition, the center of the light blocking member 570 may be disposed in a region overlapping the optical axis OA of the light emitting device 200, the center of the first air gap 551, the center of the second air gap 552, and the center of the third air gap 553 in a third direction. In the lighting device 1000 according to an embodiment, a plurality of air gaps (three or more) matching them, such as the first air gap 551, the second air gap 552, and the third air gap 553, may be formed in a multilayer structure on one light emitting device 200.The first to third air gaps 551, 552, and 553 are provided with a horizontal width greater than that of the light emitting device 200 and may have the same shape and horizontal width. In addition, the first to third air gaps 551, 552, and 553 are disposed in overlapping regions, and their centers may overlap the optical axis OA of the light emitting device 200. Due to this, it is possible to prevent a hot spot from being formed by light emitted from the light emitting device 200. In detail, the light control member 500 may control the emission direction by refracting and reflecting the incident light. Accordingly, the light control member 500 may prevent the light of the light emitting device 200 from being concentrated. When the air gap of the lighting device 1000 is formed in three or more layers as described above, the area and size of the light blocking member 570 may be minimized, thereby minimizing light loss due to the light blocking member 570. In addition, although not shown in the drawings, when the air gap of the lighting device 1000 is formed in three or more layers as described above, it is possible to effectively control the formation of a hot spot by the plurality of air gaps 551, 552, and 553. Accordingly, the lighting device 1000 may omit the above-described light blocking member 570 and thus improve the overall luminance of the output light.

FIG. 8 is another cross-sectional view of a lighting device according to a second embodiment. In the description using FIG. 8, descriptions of components identical or similar to those of the lighting device described above are omitted and the same reference numerals are given, and may be selectively applied to the present embodiment.

Referring to FIG. 8, the first air gap 551, the second air gap 552, and the third air gap 553 may be disposed at set positions. The first air gap 551, the second air gap 552, and the third air gap 553 may be disposed in regions corresponding to the light emitting device 200. For example, at least one center of the first air gap 551, the second air gap 552, and the third air gap 553 may be horizontally spaced apart from the optical axis OA of the light emitting device 200. In detail, the centers of the first air gap 551 and the third air gap 553 based on the vertical direction may be disposed in a region overlapping the optical axis OA of the light emitting device 200. In addition, the second air gap 552 may be disposed in a region where the center of the second air gap 552 does not overlap the optical axis OA of the light emitting device 200 within a range overlapping the light emitting device 200 in a vertical direction. The center of the second air gap 552 may be disposed in a region horizontally spaced apart from the optical axis OA of the light emitting device 200. That is, the first air gap 551 and the third air gap 553 may overlap and be disposed, and the second air gap 552 may partially overlap the other two air gaps 551 and 513. Accordingly, the first reflective surface 531S and the third reflective surface 533S may be disposed on the same plane, and the second reflective surface 532S may not be disposed on the same plane as the first reflective surface 531S and the third reflective surface 533S.

In another example of the lighting device 1000 according to the second embodiment of the invention, a plurality of air gaps matching them, such as the first air gap 551, the second air gap 552, and the third air gap 553, may be formed in a multilayer structure. At this time, at least one air gap selected from the first air gap 551, the second air gap 552, and the third air gap 553 is placed in a region where its center does not overlap the optical axis OA, so that the emission direction of light incident on the light control member 500 may be more effectively controlled. Therefore, the lighting device 1000 according to the embodiment may effectively prevent hot spots from being formed, and can implement a uniform linear light source or a surface light source.

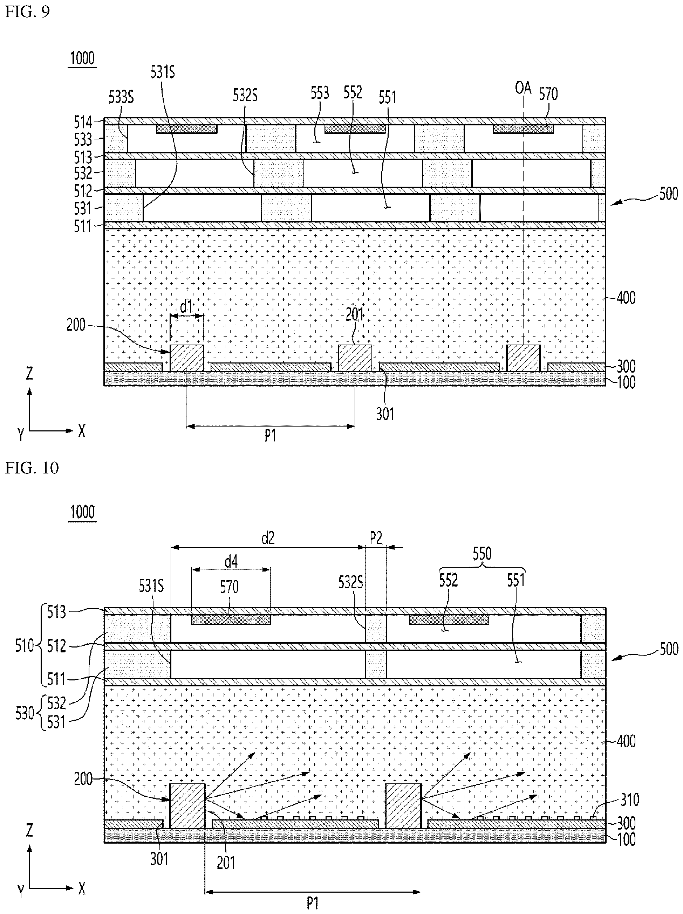

FIG. 9 is another cross-sectional view of a lighting device according to a second embodiment. In the description using FIG. 9, descriptions of components identical or similar to those of the lighting device described above are omitted and the same reference numerals are given, and may be selectively applied to the present embodiment.

Referring to FIG. 9, the first air gap 551, the second air gap 552, and the third air gap 553 may be disposed at set positions. The first air gap 551, the second air gap 552, and the third air gap 553 may be disposed in regions corresponding to the light emitting device 200. For example, at least one center of the first air gap 551, the second air gap 552, and the third air gap 553 may be horizontally spaced apart from the optical axis OA of the light emitting device 200. The first air gap 551, the second air gap 552, and the third air gap 553 may be arranged in a stepped shape. In detail, based on the vertical direction, the first air gap 551 may be disposed in a region where the center of the first air gap 551 does not overlap the optical axis OA of the light emitting device 200. Based on the vertical direction, the second air gap 552 may be disposed in a region where the center of the second air gap 552 does not overlap the optical axis OA of the light emitting device 200 within a range overlapping the light emitting device 200. Based on the vertical direction, the third air gap 553 may be disposed in a region where the center of the third air gap 553 overlaps the optical axis OA of the light emitting device 200. In this case, a horizontal distance between the center of the first air gap 551 and the optical axis OA may be greater than a horizontal distance between the center of the second air gap 552 and the optical axis OA. Accordingly, the first reflective surface 531S, the second reflective surface 532S, and the third reflective surface 533S may not be disposed on the same plane, but may be disposed stepwise in a step shape.

In another example of the lighting device 1000 according to the second embodiment of the present invention, a plurality of air gaps matching them, such as the first air gap 551, the second air gap 552, and the third air gap 553, may be formed in a multilayer structure. At this time, as the first air gap 551, the second air gap 552, and the third air gap 553 are arranged in a step shape, the emission direction of light incident on the light control member 500 may be more effectively controlled. Therefore, the lighting device 1000 according to the embodiment may effectively prevent hot spots from being formed, and can implement a uniform linear light source or a surface light source.

### <Third Embodiment>

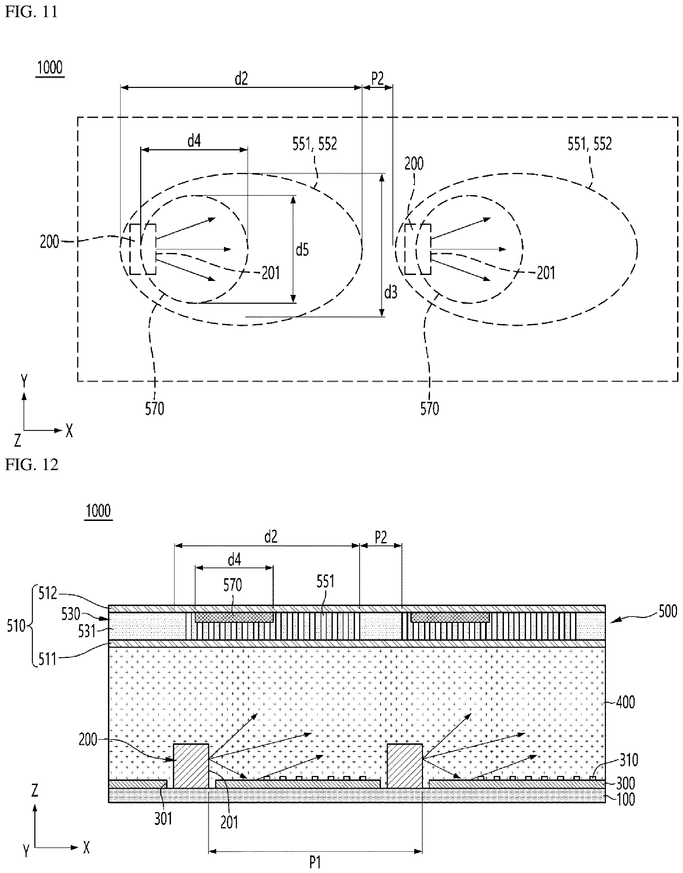

FIG. 10 is a cross-sectional view of a lighting device according to a third embodiment of the present invention, and FIG. 11 is a top view of a lighting device according to a third embodiment. In the description using FIGs. 10 and 11, descriptions of components identical or similar to those of the above-described lighting device are omitted and the same reference numerals are assigned, and may be selectively applied to the present embodiment.

Referring to FIGs. 10 and 11, the lighting device 1000 may include a substrate 100, a light emitting device 200, a reflective layer 300, a resin layer 400, and a light control member 500.

The light emitting device 200 is disposed on the substrate 100 and may be electrically connected to the substrate 100. The light emitting device 200 according to the third embodiment may have an emission surface different from that of the light emitting devices 200 according to the first and second embodiments described above. For example, the light emitting device 200 according to the third embodiment may be a side view type in which the light emitting surface 201 faces the side. In detail, the light emitting device 200 may be disposed so that the light emitting surface 201 faces a side surface of the resin layer 400. That is, the emission direction of the light emitting device 200 may be set to a lateral direction of the device, and the optical axis OA of the light emitting device 200 may be parallel to the upper surface of the substrate 100. The reflective layer 300 may be disposed on the substrate 100. The reflective layer 300 may have a plurality of reflective patterns having a dot shape. The plurality of reflective patterns 310 may be disposed in a form protruding from the upper surface of the reflective layer 300. In detail, the reflective pattern 310 may be disposed in an emission direction of the light emitting device 200. The dot pattern density of the plurality of reflective patterns 310 may increase as the distance from the light emitting device 200 increases. For example, the density of the reflective pattern 310 per unit area may increase as the distance from the optical axis OA of the light emitting device 200 increases in a horizontal direction. Also, the size of the plurality of reflective patterns 310 may change as the distance from the light emitting device 200 increases. For example, the width of the plurality of reflective patterns 310 in the horizontal direction may increase as the distance from the optical axis OA of the light emitting device 200 increases in the horizontal direction.

The light control member 500 may be disposed on the resin layer 400. The light control member 500 may include a first substrate 511, a second substrate 512, a first adhesive member 531, a third substrate 513 and a second adhesive member 532. The first adhesive member 531 may be disposed between the first substrate 511 and the second substrate 512. The first adhesive member 531 may be an adhesive layer that adheres the first substrate 511 and the second substrate 512 together. The first adhesive member 531 may be disposed in a set region. For example, the first adhesive member 531 may be disposed in a partial region between the first substrate 511 and the second substrate 512, and a first air gap 551 may be formed in the remaining region where the first adhesive member 531 is not disposed. The first air gap 551 may be a region surrounded by the first adhesive member 531 in a region between the first substrate 511 and the second substrate 512. The first air gap 551 may have a hole shape extending between the first substrate 511 and the second substrate 512. The first air gap 551 is formed as an air layer or a vacuum layer, and at least one may be disposed in a region between the first substrate 511 and the second substrate 512.

The first air gap 551 may form a first reflective surface 531S. The first reflective surface 531S may be a side surface of the first adhesive member 531. In detail, the first reflective surface 531S may be a side surface of the first adhesive member 531 exposed by the first air gap 551. The first reflective surface 531S may be perpendicular to the upper surface of the first substrate 511. Alternatively, the first reflective surface 531S may be disposed inclined to have a predetermined inclination angle with the upper surface of the first substrate 511. The first reflective surface 531S may reflect light incident to a surface formed by a difference in refractive index between the first air gap 551 and the first adhesive member 531. Accordingly, the light control member 500 refracts and reflects the light emitted from the light emitting device 200 in a set direction, thereby preventing a hot spot phenomenon in which light is concentrated. To this end, the first air gap 551 is disposed in a region corresponding to the light emitting devices 200 in a vertical direction and may be provided in plural numbers equal to the number of the plurality of light emitting devices 200. That is, the plurality of first air gaps 551 may be arranged and matched with the plurality of light emitting devices 200 one-to-one. The plurality of first air gaps 551 may be spaced apart from each other in a region between the first substrate 511 and the second substrate 512. In this case, the plurality of first air gaps 551 may be spaced apart from each other at equal intervals. For example, the distance between the plurality of first air gaps 551 may be about 0.1 mm to about 1 mm. The plurality of first air gaps 551 may have a set shape. For example, the first air gap 551 may have a shape extending along an emission direction of light emitted from the light emitting device 200 when viewed from above. An upper shape of the first air gap 551 may have a shape including a curved line in consideration of an angle of view of the light emitting device 200. The plurality of first air gaps 551 may have a set width. For example, the width of the first air gap 551 in the horizontal direction (x-axis or y-axis direction) may be larger than the width of the light emitting device 200 in the horizontal direction. Also, each of the plurality of first air gaps 551 may have a constant width. For example, the width of the first air gap 551 may be constant without changing from the first substrate 511 toward the second substrate 512. That is, the cross-sectional shape of the first air gap 551 may be a rectangular shape with a constant width as shown in FIG. 10.

The first air gap 551 may have widths in first and second directions. For example, the second width d2 defined as the width of the first air gap 551 in the first direction may be about 4 to about 25 times the width of the light emitting device 200 in the first direction. In detail, the second width d2 may be about 4 to about 20 times the width of the light emitting device 200 in the first direction. Also, the third width d3 defined as the width of the first air gap 551 in the second direction may be about 1.5 to about 5 times the width of the light emitting device 200 in the second direction. In detail, the third width d3 may be about 1.5 to about 4 times the width of the light emitting device 200 in the second direction. That is, the second width d2 of the first air gap 551 corresponding to the light emitting direction of the light emitting device 200 may be greater than the third width d3. The first air gaps 551 may be spaced apart at a second pitch interval P2 based on the horizontal direction. Here, the second pitch interval P2 may be the shortest interval between horizontally adjacent first air gaps 551. The second pitch interval P2 may be smaller than the first pitch interval P1 of the light emitting devices 200. Here, the first pitch interval P1 may mean an interval between the light emitting surfaces 201 of the light emitting devices 200.

The second adhesive member 532 may be disposed between the second substrate 512 and the third substrate 513. The second adhesive member 532 may be an adhesive layer that bonds the second substrate 512 and the third substrate 513 together. The second adhesive member 532 may be disposed in a set region. For example, the second adhesive member 532 may be disposed in some regions between the second substrate 512 and the third substrate 513, and a second air gap 552 may be formed in the remaining regions where the second adhesive member 532 is not disposed. The second air gap 552 may be a region surrounded by the second adhesive member 532 in a region between the second substrate 512 and the third substrate 513. The second air gap 552 may have a hole shape extending between the second substrate 512 and the third substrate 513. The second air gap 552 is formed as an air layer or a vacuum layer, and at least one of the second air gaps 552 may be disposed in a region between the second substrate 512 and the third substrate 513. The second air gap 552 may form a second reflective surface 532S. The second reflective surface 532S may be a side surface of the second adhesive member 532. In detail, the second reflective surface 532S may be a side surface of the second adhesive member 532 exposed by the second air gap 552. The second reflective surface 532S may be perpendicular to the upper surface of the second substrate 512. Alternatively, the second reflective surface 532S may be disposed inclined to have a predetermined inclination angle with the upper surface of the second substrate 512. The second reflective surface 532S may reflect light incident to a surface formed by a difference in refractive index between the second air gap 552 and the second adhesive member 532. The second reflective surface 532S may be parallel to the first reflective surface 531S. In detail, the second reflective surface 532S may be disposed on the same plane as the first reflective surface 531S. Accordingly, the light control member 500 refracts and reflects the light emitted from the light emitting device 200 in a set direction, thereby preventing a hot spot phenomenon in which light is concentrated. To this end, the second air gap 552 may be disposed in a region corresponding to the light emitting device 200 and the first air gap 551 in a vertical direction. That is, the center of the second air gap 552 may overlap the center of the first air gap 551 in a vertical direction. Also, the second air gaps 552 may be provided in plural numbers equal to the number of the plurality of light emitting devices 200 and the plurality of first air gaps 551. That is, the plurality of second air gaps 552 may be arranged in a one-to-one matching manner with the plurality of light emitting devices 200 and the plurality of first air gaps. The plurality of second air gaps 552 may be spaced apart from each other in an area between the second substrate 512 and the third substrate 513. In this case, the plurality of second air gaps 552 may be spaced apart from each other at equal intervals. For example, the distance between the plurality of second air gaps 552 may be about 0.1 mm to about 1 mm.

The plurality of second air gaps 552 may have a set shape. For example, the second air gap 552 may have a shape extending along an emission direction of light emitted from the light emitting device 200 when viewed from above. An upper shape of the second air gap 552 may have a shape including a curved line in consideration of an angle of view of the light emitting device 200. The second air gap 552 may have the same top shape as the first air gap 551. The plurality of second air gaps 552 may have a set width. For example, the width of the second air gap 552 in the horizontal direction (x-axis or y-axis direction) may be greater than the width of the light emitting device 200 in the horizontal direction. Also, each of the plurality of second air gaps 552 may have a constant width. For example, the width of the second air gap 552 may have a constant width without changing from the second substrate 512 toward the third substrate 513. That is, the cross-sectional shape of the second air gap 552 may be a rectangular shape with a constant width as shown in FIG. 10. The second air gap 552 may have widths in first and second directions. For example, the second width d2 defined as the first direction width of the second air gap 552 may be the same as the second width d2 of the first air gap 551, and may be about 4 to 25 times the first direction width of the light emitting device 200. In detail, the second width d2 of the second air gap 552 may be about 4 to about 20 times the width of the light emitting device 200 in the first direction. In addition, the third width d3 defined as the second direction width of the first air gap 551 may be the same as the third width d3 of the first air gap 551, and may be about 1.5 to 5 times the second direction width of the light emitting device 200. In detail, the third width d3 of the second air gap 552 may be about 1.5 to about 4 times the width of the light emitting device 200 in the second direction. That is, in the second air gap 552, the second width d2 corresponding to the light emitting direction of the light emitting device 200 may be greater than the third width d3, and the same width as the first air gap 551.

The second air gaps 552 may be spaced apart at a second pitch interval P2 based on the horizontal direction. Here, the second pitch interval P2 may be the shortest interval between horizontally adjacent second air gaps 552. The second pitch interval P2 of the second air gap 552 may be smaller than the first pitch interval P1 of the light emitting devices 200, and may be the same as the second pitch interval P2 of the first air gap 551.

The lighting device 1000 may include a light blocking member 570. The light blocking member 570 may be disposed on the light control member 500. The light blocking member 570 may be disposed on an outermost substrate among the plurality of substrates 511, 512, and 513. The light blocking member 570 may be disposed on a lower surface of the third substrate 513 facing the second substrate 512. The light blocking member 570 may be disposed between the third substrate 513 and the second air gap 552. When the light blocking member 570 is viewed from above, the planar shape of the light blocking member 570 may have various shapes such as a circular shape, an elliptical shape, and a polygonal shape. For example, the planar shape of the light blocking member 570 may include a curved shape in consideration of an emission direction of the light emitting device 200 and a beam angle. The light blocking members 570 are provided in the same number as the light emitting devices 200 and may be disposed in a region overlapping the light emitting devices 200 in a third direction. In addition, the light blocking member 570 may be disposed extending along an emission direction of light emitted from the light emitting device 200. The light blocking member 570 may have a fourth width d4 defined as a width in a first direction and a fifth width d5 defined as a width in a second direction. In this case, a fourth width d4 corresponding to the direction of the optical axis OA of the light emitting device 200 may be greater than the fifth width d5.

In another example of the lighting device 1000 according to the third embodiment of the invention, a plurality of air gaps 550 matched thereto, for example, the first air gap 551 and the second air gap 552, may be formed in a multilayer structure on one light emitting device 200. In this case, the first air gap 551 and the second air gap 552 extend along the emission direction of the light emitting device 200 and may have different widths in the first and second directions. Due to this, it is possible to prevent a hot spot from being formed by light emitted from the light emitting device 200. In detail, the light control member 500 may control the emission direction by refracting and reflecting the light emitted from the light emitting device 200 in a side direction and incident on the light control member 500. Accordingly, the light control member 500 may prevent light from being concentrated in a region corresponding to the emission direction of the light emitting device 200, and may provide a uniform linear light source or surface light source. Since the light control member 500 includes a plurality of air gaps, the area and size of the formed light blocking member 570 may be minimized, thereby minimizing light loss due to the light blocking member 570. Therefore, the lighting device 1000 may implement a uniform linear light source or a surface light source with improved luminance.

### <Fourth embodiment>

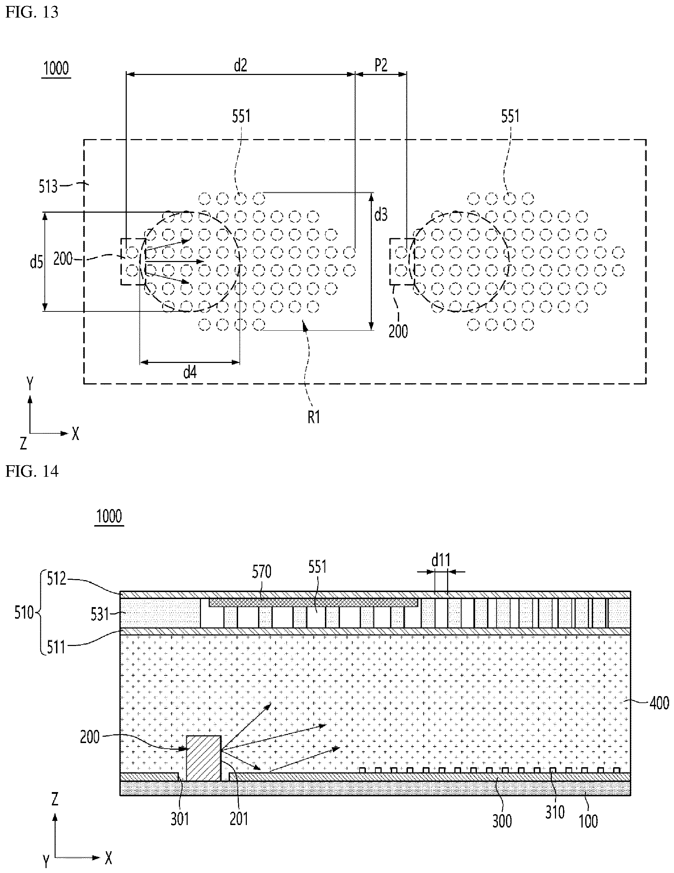

FIG. 12 is a cross-sectional view of a lighting device according to the fourth embodiment, and FIG. 13 is a top view of a lighting device according to the fourth embodiment. In the description using FIGs. 12 and 13, descriptions of components identical or similar to those of the above-described lighting device are omitted and the same reference numerals are assigned, and may be selectively applied to the present embodiment.

Referring to FIGs. 12 and 13, the lighting device 1000 may include a substrate 100, a light emitting device 200, a reflective layer 300, a resin layer 400, and a light control member 500. The light emitting device 200 may be of the same side view type as the third embodiment described above. That is, the light emitting surface 201 of the light emitting device 200 may face the side. In detail, the light emitting device 200 may be disposed such that the light emitting surface 201 faces the side surface of the resin layer 400, and the optical axis OA of the light emitting device 200 may be parallel to the upper surface of the substrate 100. The reflective layer 300 may be disposed on the substrate 100. The reflective layer 300 may have a plurality of reflective patterns having a dot shape. The plurality of reflective patterns 310 may be disposed in a form protruding from the upper surface of the reflective layer 300. The reflective pattern 310 may be disposed in an emission direction of the light emitting device 200. The dot pattern density of the plurality of reflective patterns 310 may increase as the distance from the light emitting device 200 increases. For example, the density of the reflective pattern 310 per unit area may increase as the distance from the optical axis OA of the light emitting device 200 increases in a horizontal direction. The size of the plurality of reflective patterns 310 may change as the distance from the light emitting device 200 increases. For example, the width of the plurality of reflective patterns 310 in the horizontal direction may increase as the distance from the optical axis OA of the light emitting device 200 increases in the horizontal direction.

The light control member 500 may be disposed on the resin layer 400. The light control member 500 may include a first substrate 511, a second substrate 512 and a first adhesive member 531. The first adhesive member 531 may be disposed between the first substrate 511 and the second substrate 512. The first adhesive member 531 may be an adhesive layer that bonds the first substrate 511 and the second substrate 512 together. The first adhesive member 531 may be disposed in a set region. For example, the first adhesive member 531 may be disposed in a partial region between the first substrate 511 and the second substrate 512, and a first air gap 551 may be formed in the remaining region where the first adhesive member 531 is not disposed. The first air gap 551 may be a region surrounded by the first adhesive member 531 in a region between the first substrate 511 and the second substrate 512. The first air gap 551 may have a hole shape extending between the first substrate 511 and the second substrate 512. The first air gap 551 is formed as an air layer or a vacuum layer, and at least one may be disposed in a region between the first substrate 511 and the second substrate 512.

The first air gap 551 may form a first reflective surface 531S. The first reflective surface 531S may be a side surface of the first adhesive member 531. In detail, the first reflective surface 531S may be a side surface of the first adhesive member 531 exposed by the first air gap 551. The first reflective surface 531S may be perpendicular to the upper surface of the first substrate 511. Alternatively, the first reflective surface 531S may be disposed inclined to have a predetermined inclination angle with the upper surface of the first substrate 511. The first reflective surface 531S may reflect light incident to a surface formed by a difference in refractive index between the first air gap 551 and the first adhesive member 531. Accordingly, the light control member 500 refracts and reflects the light emitted from the light emitting device 200 in a set direction, thereby preventing a hot spot phenomenon in which light is concentrated. The number of first air gaps 551 may be greater than the number of light emitting devices 200. That is, one light emitting device 200 may correspond to a plurality of first air gaps 551. The plurality of first air gaps 551 may be spaced apart from each other in an area between the first substrate 511 and the second substrate 512. In this case, the plurality of first air gaps 551 may be spaced at regular intervals, and the distance between the plurality of first air gaps 551 may be about 0.1 mm to about 1 mm. The plurality of first air gaps 551 may have a set shape. For example, when viewing the first air gap 551 from the top, the first air gap 551 may have various shapes such as a polygon, a circle, and an ellipse. The plurality of first air gaps 551 may have the same shape as each other. For example, the top shape of the plurality of first air gaps 551 may be circular as shown in FIG. 13.

The plurality of first air gaps 551 may have a set width. For example, the width of the first air gap 551 in the horizontal direction (x-axis or y-axis direction) may be smaller than the width d1 of the light emitting device 200 in the horizontal direction. For example, the horizontal width of the first air gap 551 may be about 0.1 mm to about 1 mm. The plurality of first air gaps 551 may have the same horizontal width as each other. Also, each of the plurality of first air gaps 551 may have a constant width. For example, the widths of the plurality of first air gaps 551 may have a constant width without changing from the first substrate 511 toward the second substrate 512. That is, the cross-sectional shape of the first air gap 551 may be a rectangular shape with a constant width. The plurality of first air gaps 551 may be disposed at set positions. In detail, the plurality of first air gaps 551 may be disposed in a region corresponding to the light emitting device 200. For example, a portion of the plurality of first air gaps 551 in the vertical direction (z-axis direction) may be disposed in a region overlapping the light emitting device 200. In addition, the rest of the plurality of first air gaps 551 may be disposed in a region that does not overlap with the light emitting device 200, for example, a region corresponding to the emission direction of the light emitting device 200.

A region where the plurality of first air gaps 551 are disposed may be defined as a first region R1. Here, the first region R1 may be a region in which a plurality of first air gaps 551 matching one light emitting device 200 are disposed. For example, the first region R1 in FIG. 13 may refer to a region in which outer sides of the plurality of first air gaps 551 positioned at the outermost part are connected in a straight line. The first region R1 may have a shape corresponding to an emission direction of light emitted from the light emitting device 200 and may have a set size. For example, the second width d2 defined as the width of the first region R1 in the first direction may be about 4 to about 25 times the width of the light emitting device 200 in the first direction. In detail, the second width d2 may be about 4 to about 20 times the width of the light emitting device 200 in the first direction. Also, the third width d3 defined as the width of the first region R1 in the second direction may be about 1.5 to about 5 times the width of the light emitting device 200 in the second direction. In detail, the third width d3 may be about 1.5 to about 4 times the width of the light emitting device 200 in the second direction. That is, the second width d2 of the first region R1 corresponding to the light emitting direction of the light emitting device 200 may be greater than the third width d3. The first regions R1 may be spaced apart at a second pitch interval P2 based on the horizontal direction. Here, the second pitch interval P2 may be the shortest interval between horizontally adjacent first regions R1. The second pitch interval P2 may be smaller than the first pitch interval P1 of the light emitting devices 200.

The lighting device 1000 may include a light blocking member 570. The light blocking member 570 may be disposed between the first substrate 511 and the second substrate 512. The light blocking member 570 may be disposed on the lower surface of the second substrate 512. The light blocking member 570 may be disposed between the second substrate 512 and the first adhesive member 531. Also, the light blocking member 570 may be disposed between the second substrate 512 and the plurality of first air gaps 551. When the light blocking member 570 is viewed from above, the planar shape of the light blocking member 570 may have various shapes such as a circular shape, an elliptical shape, and a polygonal shape. For example, the planar shape of the light blocking member 570 may include a curved shape in consideration of an emission direction of the light emitting device 200 and a beam angle. The light blocking members 570 are provided in the same number as the light emitting devices 200 and may be disposed in a region overlapping the light emitting devices 200 in a third direction (z-axis direction). Also, a portion of the light blocking member 570 may be disposed in a region overlapping a portion of the plurality of first air gaps 551 in the third direction. The light blocking member 570 may have a fourth width d4 defined as a width in a first direction and a fifth width d5 defined as a width in a second direction. In this case, a fourth width d4 corresponding to the direction of the optical axis OA of the light emitting device 200 may be greater than the fifth width d5. Also, the fourth and fifth widths d4 and d5 of the light blocking member 570 may be greater than the horizontal width of the first air gap 551.

The lighting device 1000 according to the fourth embodiment of the invention may include a plurality of first air gaps 551 corresponding to one light emitting device 200, and each of the plurality of first air gaps 551 may have a width smaller than that of the light emitting device 200. In addition, the plurality of first air gaps 551 may extend along the emission direction of the light emitting device 200 and may have different widths in the first and second directions. Due to this, it is possible to prevent a hot spot from being formed by light emitted from the light emitting device 200. In detail, the light control member 500 may control the emission direction by refracting and reflecting the light emitted from the light emitting device 200 in a side direction and incident on the light control member 500. Accordingly, the light control member 500 can prevent light from being concentrated in a region corresponding to the emission direction of the light emitting device 200, and may provide a uniform linear light source or surface light source. Also, since the lighting device 1000 forms a plurality of first air gaps 551 on one adhesive member, the light control member 500 may have a smaller thickness.

FIG. 14 is another cross-sectional view of a lighting device according to a fourth embodiment. In the description using FIG. 14, the same reference numerals are assigned to the same or similar configurations as those of the lighting device described above, and the same reference numerals are assigned, and may be selectively applied to the present embodiment.

Referring to FIG. 14, the number of first air gaps 551 may be greater than the number of light emitting devices 200. That is, one light emitting device 200 may correspond to a plurality of first air gaps 551. The plurality of first air gaps 551 may have a set shape. For example, when viewing the first air gap 551 from the top, the first air gap 551 may have various shapes such as a polygon, a circle, and an ellipse. The plurality of first air gaps 551 may have the same shape as each other. The plurality of first air gaps 551 may have a set width. A horizontal width (x-axis or y-axis direction) width d11 of the first air gap 551 may be smaller than a horizontal width d1 of the light emitting device 200. For example, the width d11 of the first air gap 551 in the horizontal direction may be about 0.1 mm to about 1 mm. Also, the width d 11 of each of the plurality of first air gaps 551 in the horizontal direction may be constant. In detail, the width d11 of the plurality of first air gaps 551 in the horizontal direction may have a constant width without changing in the direction from the first substrate 511 to the second substrate 512. That is, the cross-sectional shape of each of the plurality of first air gaps 551 may be a rectangular shape having a constant width. The width d11 of the plurality of first air gaps 551 in the horizontal direction may vary within the aforementioned range. For example, the width of the plurality of first air gaps 551 in a horizontal direction may decrease as the distance from the light emitting device 200 increases. That is, the first air gap 551 located at the farthest distance from the light emitting device 200 may have the smallest horizontal width among the plurality of first air gaps 551. A density of the plurality of first air gaps 551 may vary according to a distance from the light emitting device 200. For example, the density of the first air gap 551 per unit area may increase as the distance from the light emitting device 200 increases.

Accordingly, the fourth embodiment of the invention may prevent the formation of a hot spot in which light is concentrated due to the light emitted from the light emitting device 200. In detail, the lighting device 1000 according to the embodiment may control the formation of a hot spot by controlling the location, width, and density of the first air gap 551, and may minimize light loss due to the light control member 500. Therefore, the lighting device 1000 according to the embodiment may implement a uniform linear light source or a surface light source with improved luminance.

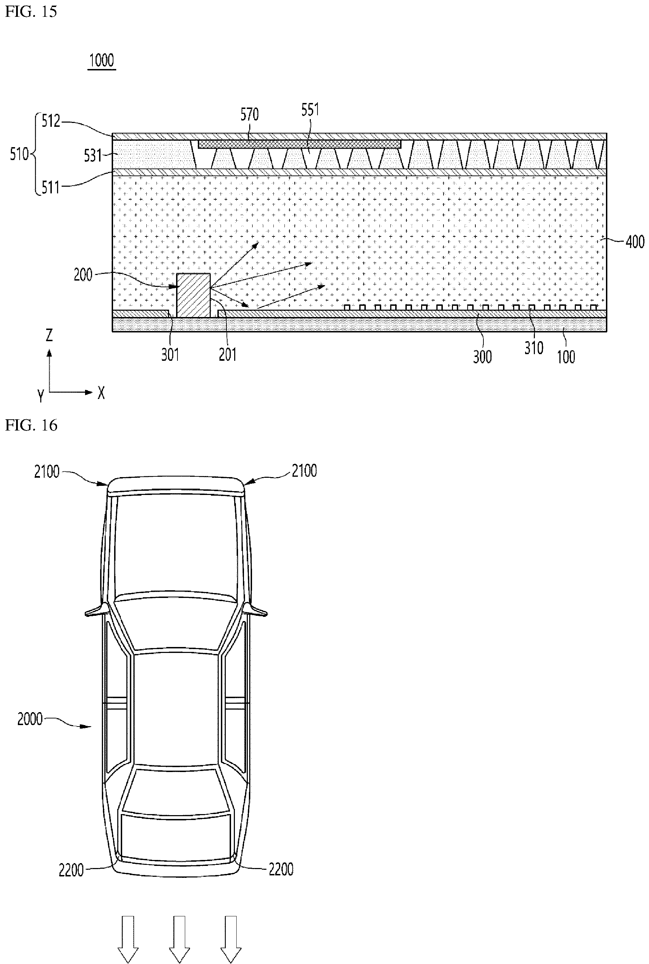

FIG. 15 is another cross-sectional view of a lighting device according to a fourth embodiment. In the description using FIG. 15, descriptions of components identical or similar to those of the lighting device described above are omitted and the same reference numerals are assigned, and may be selectively applied to the present embodiment.

Referring to FIG. 15, the number of first air gaps 551 may be greater than the number of light emitting devices 200. That is, one light emitting device 200 may correspond to a plurality of first air gaps 551. The plurality of first air gaps 551 may have a set shape. For example, when viewing the first air gap 551 from the top, the first air gap 551 may have various shapes such as a polygon, a circle, and an ellipse. The plurality of first air gaps 551 may have the same shape as each other. The plurality of first air gaps 551 may have a set width. A width of the first air gap 551 in a horizontal direction (x-axis or y-axis direction) may be smaller than a width d1 of the light emitting device 200 in a horizontal direction. A horizontal width of each of the plurality of first air gaps 551 may vary. In detail, the horizontal width of each of the plurality of first air gaps 551 may change from the first substrate 511 to the second substrate 512. For example, a horizontal width of each of the plurality of first air gaps 551 may increase from the first substrate 511 to the second substrate 512. That is, the cross-sectional shape of each of the plurality of first air gaps 551 may be a trapezoidal shape with an increasing width, and the first reflective surface 531S may be disposed inclined at a predetermined inclination angle with respect to the upper surface of the first substrate 511. A horizontal width of the first air gap 551 may be about 0.1 mm to about 1 mm. The horizontal width of the plurality of first air gaps 551 may vary within the aforementioned range. For example, the width of the plurality of first air gaps 551 in a horizontal direction may decrease as the distance from the light emitting device 200 increases. That is, the first air gap 551 located at the farthest distance from the light emitting device 200 may have the smallest horizontal width among the plurality of first air gaps 551.

A density of the plurality of first air gaps 551 may vary according to a distance from the light emitting device 200. For example, the density of the first air gap 551 per unit area may increase as the distance from the light emitting device 200 increases. Accordingly, the fourth embodiment may prevent formation of a hot spot where light is concentrated by the light emitted from the light emitting device 200. In detail, the lighting device 1000 according to the embodiment may control the formation of a hot spot by controlling the position, width, density, and inclination angle of the first reflective surface 531S, and may minimize light loss due to the light control member 500. Therefore, the lighting device 1000 according to the embodiment can implement a uniform linear light source or a surface light source with improved luminance.

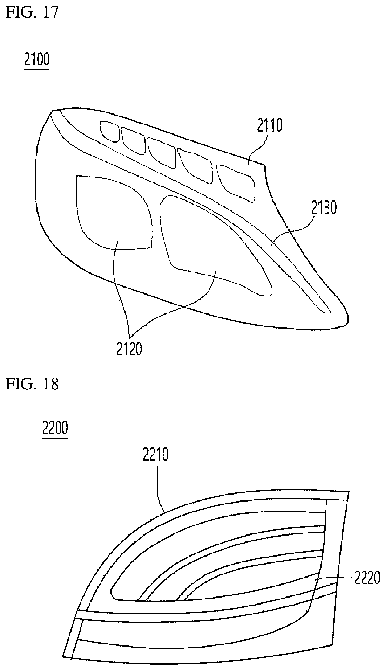

FIG 16 to FIG 18 are views illustrating examples in which a lamp including a lighting device according to an embodiment is applied to a vehicle. In detail, FIG. 16 is a top view of a vehicle to which the lamp having the lighting device is applied, FIG. 17 is an example in which the lighting device according to the embodiment is placed in front of the vehicle, and FIG. 18 is an example in which the lighting device according to the embodiment is placed in the rear of the vehicle.

Referring to FIGs. 16 to 18, a lighting device 1000 according to an embodiment may be applied to a vehicle 2000. One or more lamps may be disposed in at least one of the front, rear, and lateral sides of the vehicle 2000. For example, referring to FIG. 17, the lamp may be applied to a front lamp 2100 of a vehicle. The front lamp 2100 may include a first cover member 2110 and at least one first lamp module 2120 including the lighting device 1000. The first cover member 2110 accommodates the first lamp module 2120 and may be made of a light-transmissive material. The first cover member 2110 may have a curve according to the design of the vehicle 2000 and may be provided in a flat or curved shape according to the shape of the first lamp module 2120. The front lamp 2100 may provide a plurality of functions by controlling the driving timing of the lighting device 1000 included in the first lamp module 2120. For example, the front lamp 2100 may provide at least one function of a headlamp, a turn signal lamp, a daytime running lamp, a high lamp, a low lamp, and a fog lamp by light emission of the lighting device 1000. In addition, the front lamp 2100 may provide additional functions such as a welcome light or a celebration effect when the driver opens the vehicle door.

Referring to FIG. 18, the lamp may be applied to a rear lamp 2200 of a vehicle. The rear lamp 2200 may include a second cover member 2210 and at least one second lamp module 2220 including the lighting device 1000. The second cover member 2210 accommodates the second lamp module 2220 and may be made of a light-transmissive material. The second cover member 2210 may have a curve according to the design of the vehicle 2000 and may be provided in a flat or curved shape according to the shape of the second lamp module 2220. The back lamp 2200 may provide a plurality of functions by controlling the driving timing of the lighting device 1000 included in the second lamp module 2220. For example, the rear lamp 2200 may provide at least one function of a sidelight, a brake light, and a direction indicator light by light emitted from the lighting device 1000.

## Claims

1. A lighting device comprising:
a substrate;
a light emitting device disposed on the substrate;
a reflective layer disposed on the substrate;
a resin layer disposed on the reflective layer; and
a light control member disposed on the resin layer;
wherein the light control member comprises:
a first substrate disposed on the resin layer;
a second substrate disposed on the first substrate; and
a first adhesive member disposed between the first and second substrates,
wherein a region between the first and second substrates includes a first air gap formed in a region where the first adhesive member is not disposed, and
wherein a number of the first air gap is greater than or equal to a number of the light emitting device.

2. The lighting device of claim 1, wherein the number of first air gap is provided in plurality, which is greater than the number of light emitting device, and
wherein a width of each of the plurality of first air gaps in a horizontal direction is smaller than a width of the light emitting device in the horizontal direction.

3. The lighting device of claim 2, wherein a portion of the plurality of first air gaps is disposed in a region overlapping the light emitting device in a vertical direction.

4. The lighting device of claim 1, wherein the light control member further comprises:
a third substrate disposed on the second substrate; and
a second adhesive member disposed between the second and third substrates,
wherein a region between the second and third substrates includes a second air gap formed in a region where the second adhesive member is not disposed,
wherein a number of each of the first and second air gaps is the same as the number of light emitting device.

5. The lighting device of claim 4, wherein the first and second air gaps have the same shape and the same width in a horizontal direction.

6. The lighting device of claim 4, comprising a light blocking member disposed between the third substrate and the second air gap,
wherein a width of the light blocking member in a horizontal direction is smaller than widths of the first and second air gaps in the horizontal direction.

7. The lighting device of any one of claims 4 to 6, wherein centers of the first and second air gaps overlap an optical axis of the light emitting device in a vertical direction.

8. The lighting device of any one of claims 4 to 6, wherein a center of the first air gap is spaced apart from an optical axis of the light emitting device in a horizontal direction, and
wherein a center of the second air gap overlaps an optical axis of the light emitting device in a vertical direction.

9. The lighting device of any one of claims 3 to 5, comprising a light blocking member disposed between the second substrate and the first air gap, and a width of the light blocking member in a horizontal direction is greater than a width of the first air gap in the horizontal direction.

10. A lighting device comprising:
a substrate;
a light emitting device disposed on the substrate;
a reflective layer disposed on the substrate;
a resin layer disposed on the reflective layer; and
a light control member disposed on the resin layer;
wherein the light control member comprises:
a first substrate disposed on the resin layer;
a second substrate disposed on the first substrate; and
a first adhesive member disposed between the first and second substrates,
a region between the first and second substrates includes a first air gap formed in where the first adhesive member is not disposed,
wherein a light emitting surface of the light emitting device faces a side surface of the resin layer, and
wherein a number of the first air gap is greater than or equal to a number of light emitting device.

11. The lighting device of claim 10, wherein the number of first air gap is provided in plurality, which is greater than the number of light emitting device, and
wherein a width of each of the plurality of first air gaps in a horizontal direction is smaller than a width of the light emitting device in the horizontal direction.

12. The lighting device of claim 11, wherein a portion of the plurality of first air gaps is disposed in a region overlapping the light emitting device in a vertical direction.

13. The lighting device of claim 11 or 12, wherein widths of the plurality of first air gaps in the horizontal direction decrease as a distance from the light emitting device increases.

14. The lighting device of claim 11 or 12, wherein the width of each of the plurality of first air gaps in the horizontal direction changes from the first substrate toward the second substrate.
